(19)

Europäisches
Patentamt
European
Patent Office
Office européen
des brevets

(11)  **EP 2 051 140 A1**

(12)  **EUROPEAN PATENT APPLICATION**

(43) Date of publication:
**22.04.2009  Bulletin 2009/17**

(51) Int Cl.:
*G03F 7/20* (2006.01)          *H05G 2/00* (2006.01)
*G21K 1/00* (2006.01)

(21) Application number: **08018235.5**

(22) Date of filing: **17.10.2008**

(84) Designated Contracting States:
**AT BE BG CH CY CZ DE DK EE ES FI FR GB GR
HR HU IE IS IT LI LT LU LV MC MT NL NO PL PT
RO SE SI SK TR**
Designated Extension States:
**AL BA MK RS**

(30) Priority:  **17.10.2007  JP 2007270121**

(71) Applicants:
• **Tokyo Institute of Technology
Tokyo 152-8550 (JP)**
• **USHIODENKI KABUSHIKI KAISHA
Chiyoda-ku,
Tokyo (JP)**

(72) Inventors:
• **Hosokai, Tomonao
Taito-ku
Tokyo-to (JP)**

• **Horioka, Kazuhiko
Midori-ku
Yokohama-shi
Kanagawa-ken (JP)**
• **Seki, Kyohei
Himeji-shi
Hyogo-ken (JP)**
• **Mizokoshi, Hiroshi
Gotenba-shi
Shizuoka-ken (JP)**

(74) Representative: **Tomerius, Isabel et al
Lang & Tomerius
Patentanwälte
Landsberger Strasse 300
80687 München (DE)**

(54)  **An extreme ultraviolet light source device and a method for generating extreme ultraviolet radiation**

(57)  High temperature plasma raw material (21) is added drop-wise, for example, and evaporated by irradiation with a laser beam (23). The laser beam (23) passes through a discharge area between a pair of electrodes (21) and irradiates the high temperature plasma raw material (11,12). Pulsed power is applied to the space between the electrodes (11,12) in such a way that discharge current reaches a specified threshold value (Ip) at a time when at least part of the evaporated material reaches the discharge channel. As a result, discharge starts between the electrodes (11,12), plasma is heated and excited and then EUV radiation is generated. The EUV radiation thus generated passes through a foil trap (3), is collected by EUV radiation collector optics (2) and then extracted. The irradiation of the laser beam (23) allows selling of the space density of the high temperature plasma raw material (21) to a specified distribution and defining of the position of a discharge channel.

Fig. 4

## Description

Background of the Invention

Field of Invention

The present invention relates to an extreme ultraviolet light source device for generating extreme ultraviolet radiation from plasma generated by electric discharge and a method of generating extreme ultraviolet radiation. Especially, the present invention relates to an extreme ultraviolet light source device and a method of generating extreme ultraviolet radiation which generates extreme ultraviolet radiation using plasma generated by discharge following gasification of a high temperature plasma raw material by energy beam irradiation of a high temperature plasma raw material for generation of extreme ultraviolet radiation that is supplied to the vicinity of the discharge electrodes.

Description of Related Art

With the micro-miniaturization and higher integration of semiconductor integrated circuits, there are demands for improved resolution in projection lithography devices used in manufacturing integrated circuits. Lithography radiation wavelengths have gotten shorter, and extreme ultraviolet light source devices (hereafter, EUV radiating species devices) that radiate extreme ultraviolet (hereafter EUV) radiation with wavelengths from 13 nm to 14 nm, and particularly, the wavelength of 13.5 nm, have been developed as a next generation semiconductor lithography light source to follow excimer laser devices to meet these demands.

A number of methods of generating EUV radiation are known in EUV radiating species devices; one of these is a method in which high temperature plasma is generated by heating and excitation of an extreme ultraviolet radiating species (hereafter EUV radiating species) and extracting the EUV radiation radiated by the plasma. EUV radiating species devices using this method can be roughly divided, by the type of high temperature plasma generation, into LPP (laser-produced plasma) type EUV radiating species devices and DPP (discharge-produced plasma) type EUV radiating species devices (see, "Status and Prospects of Research on EUV (Extreme Ultraviolet) Light Sources for Lithography," J. Plasma Fusion Res. Vol. 79, No.3, p. 219-260, March 2003, for example).

LPP-type EUV radiating species devices use EUV radiation from a high temperature plasma produced by irradiating a solid, liquid, or gaseous target with a pulsed laser. DPP-type EUV radiating species devices, on the other hand, use EUV radiation from a high temperature plasma produced by electrical current drive.

A radiating species that radiates 13.5 nm EUV radiation-that is, Xe (xenon) with a valence of about 10 as a high temperature plasma raw material for generation of EUV-is known in both these types of EUV radiating species devices, but Li (lithium) and Sn (tin) ions have been noted as high temperature plasma raw materials that yield a greater radiation intensity. For example, Sn has a conversion efficiency, which is the ratio of 13.5 nm wavelength EUV radiation intensity to the input energy for generating high temperature plasma, several times greater than that of Xe.

As a method for generation of high temperature plasma, methods that combine laser beam irradiation of a high temperature plasma raw material and heating with a large discharge-based current (also called "hybrid method" hereafter) have been proposed in recent years. EUV radiating species devices using a hybrid method include, for example, that described in JP-A-2005-522839 and corresponding US 6,972,421 B2. It is explained in outline below.

The hybrid method in the EUV light source device described in JP-A-2005-522839 and corresponding US 6,972,421 B2 uses the following process. Figure 4C of JP-A-2005-522839 (US 6,972,421 B2) explains the EUV light source device using the hybrid method. In that figure, a grounded outer electrode forms the discharge vessel. An insulator is placed inside the outer electrode, and a high voltage side inner electrode is placed inside the insulator. A gas, such as xenon (Xe) gas or a mixture of xenon (Xe) and helium (He), for example, is used as the high temperature plasma raw material. This high temperature plasma raw material gas is supplied to the discharge vessel by a gas path fitted to the inner electrode. Such things as an RF pre-ionization coil for pre-ionization of the high temperature plasma raw material gas and a focusing lens to focus the laser beam are installed in the discharge vessel.

A description of the generation of EUV radiation is given below. First, raw material gas, which is a high temperature plasma raw material introduced into the discharge vessel, undergoes pre-ionization when pulsed power is supplied to the RF pre-ionization coil. Then, a laser beam that has passed through the focusing lens is focused on a specified region within the discharge vessel. Because the high temperature plasma raw material gas has undergone pre-ionization, it is broken down near the laser focal point.

Next, pulsed power is applied between the outer electrode and the inner electrode, and a discharge is generated. By means of the pinch effect from the discharge, the high temperature plasma raw material is heated and excited and a high temperature plasma is generated; EUV radiation is produced from this high temperature plasma.

Here, electric conductivity is decreased by the emission of electrons in the vicinity of the laser focal point. Accordingly, the position of the discharge channel in the discharge region (the space where discharge occurs between the electrodes) is fixed at the position where the laser focal point is set. That is, the plasma pinch position is demarcated by the laser beam. For that reason, the positional stability of the point of generation of EUV radiation is improved.

Here, electric conductivity is increased by the emission of electrons in the vicinity of the laser focal point. Accordingly, the position of the discharge channel in the discharge region (the space where discharge occurs between the electrodes) is demarcated at the position where the laser focal point is set. That is, the plasma pinch position is demarcated by the laser beam. For that reason, the positional stability of the point of generation of EUV radiation is improved.

In the event that the EUV light source device is used as a light source for lithography, precision of the pointing stability of the point of emission is demanded. The hybrid method EUV light source device described in JP-A-2005-522839 and corresponding US 6,972,421 B2 may be said to be a response to that demand.

Now, the discharge between the electrodes starts as a vacuum arc discharge in a relatively broad region and shifts to a gas discharge (including the pinch discharge) along with the supply of high temperature plasma raw material. Then a discharge column (plasma column) is formed, but what is called the "discharge region" in this specification is defined as a space that includes all these discharge phenomena.

Further, within the discharge region, when the internal current density of the discharge increases and the discharge shifts to a gas discharge as the discharge column (plasma column) grows, there is a spatial region with high current density in the discharge column in which discharge-driven current is dominant; this spatial region is defined as a "discharge channel." Here, the discharge channel is the region where discharge-driven current is the dominant flow, and so this discharge channel is also called a discharge path or discharge current path.

However, the following problems arise in the constitution of a device such as shown in JP-A-2005-522839 and corresponding US 6,972,421 B2.

In the EUV light source device described above, the position of the discharge channel is demarcated by laser beam irradiation. To realize EUV emission with good efficiency, however, it is necessary to set the high temperature plasma raw material (gas) distribution in the discharge channel to the desired spatial density distribution.

In other words, even if the position of the discharge channel is demarcated, EUV radiation with a wavelength of 13.5 nm will not be produced by the plasma generated by the discharge unless the high temperature plasma raw material (gas) distribution in the discharge channel is the desired spatial density distribution.

In the EUV light source device of JP-A-2005-522839 and corresponding US 6,972,421 B2, the raw material gas is supplied to the discharge vessel by a gas path installed in the inner electrode. It is not possible, however, to actively control the spatial density distribution of the high temperature plasma raw material (gas) distribution in the discharge channel, and so the high temperature plasma raw material (gas) spatial density distribution that is optimal for EUV emission will not necessarily be available in the discharge channel.

Summary of the Invention

The present invention was achieved in view of the aforementioned circumstances. The object of the present invention is to provide an EUV light source device that allows the position of a discharge channel to be defined and proper setting of the density of high temperature plasma raw material (gas) in the discharge channel and a method of generating EUV.

Brief Description of the Drawings

Fig. 1 is a timing chart (1) explaining the EUV generation according to the present invention.

Fig. 2 is a schematic view (1) explaining the relation between the electrodes, the raw material supply position and the radiating position of the laser beam.

Fig. 3 is a schematic view (2) explaining the relation between the electrodes, the raw material supply position and the radiating position of the laser beam.

Fig. 4 is a view showing the cross-sectional configuration (front view) of the EUV light source device according to the present invention.

Fig. 5 is a view showing the cross-sectional configuration (top view) of the EUV light source device according to the present invention.

Fig. 6 is a view explaining the monitoring of the position of raw material added drop-wise from a raw material supply unit.

Fig. 7 is a flowchart (1) showing the operation of the embodiment as shown in Fig. 4 and Fig. 5.

Fig. 8 is a flowchart (2) showing the operation of the embodiment as shown in Fig. 4 and Fig. 5.

Fig. 9 is a time chart showing the operation of the embodiment as shown in Fig. 4 and Fig. 5.

Fig. 10 is a view showing a first alternative embodiment (front view) of the EUV light source device according to the embodiment as shown in Fig. 4 and Fig. 5.

Fig. 11 is a view showing the first alternative embodiment (top view) of the EUV light source device according to the embodiment as shown in Fig. 4 and Fig. 5.

Fig. 12 is a view showing a second alternative embodiment (front view) of the EUV light source device according to the embodiment as shown in Fig. 4 and Fig. 5.

Fig. 13 is a view showing the second alternative embodiment (top view) of the EUV light source device according to the embodiment as shown in Fig. 4 and Fig. 5.

Fig. 14 is a view showing the second alternative embodiment (side view) of the EUV light source device according to the embodiment as shown in Fig. 4 and Fig. 5.

Fig. 15 is a view showing a third alternative embodiment (top view) of the EUV light source device according to the embodiment as shown in Fig. 4 and Fig. 5.

Fig. 16 is a view showing the third alternative embodiment (side view) of the EUV light source device according to the embodiment as shown in Fig. 4 and Fig. 5.

Fig. 17 is a flowchart (1) showing the operation of the first alternative embodiment of the EUV light source device according to the embodiment as shown in Fig. 4 and Fig. 5.

Fig. 18 is a flowchart (2) showing the operation of the first alternative embodiment of the EUV light source device according to the embodiment as shown in Fig. 4 and Fig. 5.

Fig. 19 is a time chart showing the operation of the first alternative embodiment of the EUV light source device according to the embodiment as shown in Fig. 4 and Fig. 5.

Fig. 20 is a schematic views of the case in which a high-speed jet nozzle for spraying raw material is mounted at the radiating position of an energy beam.

Fig. 21 is a schematic views of the case in which a high-speed jet nozzle for spraying raw material is mounted at the radiating position of an energy beam and a constricted area provided at a portion of the inside of the nozzle.

Fig. 22 is a view showing the case in which a raw material supply part for supplying high temperature plasma raw material and a high-speed jet nozzle are integrally constructed.

Detailed Description of the Invention

The EUV light source device according to the present invention vaporizes a radiating species that emits EUV radiation with a wavelength of 13.5 nm (i.e., high temperature plasma raw material such as solid or liquid Sn, Li or the like) by irradiation with an energy beam. Vaporized high temperature plasma raw material spreads at a specific speed centering on the normal direction of the surface of high temperature plasma raw material on which an energy beam is incident.

The high temperature plasma raw material that was vaporized by the irradiation of an energy beam and spread at a specific speed is supplied to a discharge area by properly setting the positions of the discharge area and raw material, the direction of radiation with an energy beam to the raw material, the irradiation energy of the energy beam and the like.

The energy beam includes a laser beam, an ion beam and an electron beam.

That is, it is possible to set the spatial density distribution of vaporized high temperature plasma raw material to a specified distribution in the discharge area by properly setting the intensity (energy) of the energy beam and the direction of irradiation.

Moreover, by irradiating the energy beam to a specified position, electric discharge is initiated and the position of the discharge channel is fixed to the radiating position of the energy beam. If the energy beam is a laser beam, by allowing the laser beam to pass through a specified position in the discharge area at a specified power density, the position of the discharge channel can be fixed to the position where the laser beam has passed through, whereby the positional stability of the originating point of EUV radiation can be enhanced.

As described above, since electric discharge is initiated at a time when an energy beam irradiates a specified position in the discharge area, it is possible to control the initiating timing of discharge by controlling the radiation timing of the energy beam.

Here, in a discharge channel whose position is defined by the radiation of an energy beam, the radiation timing of the energy beam and the timing of applying pulsed power to the gap between the electrodes can properly be set in such a way that a discharge current value generated in the discharge area exceeds the lower limit of the discharge current value needed for generating EUV radiation of a specific intensity at a time when at least part of the vaporized raw material having a specified spatial density distribution reaches the discharge channel. As a result, efficient EUV radiation can be achieved.

A description of (1) the radiation timing of an energy beam, (2) the relationship between the position of the electrodes, the position of the raw material supply and the radiating position of the energy beam and (3) the energy of the energy beam is given below. Here, the energy beam is exemplified by a laser beam.

(1) Timing

A description of the method of EUV generation according to the present invention is given below by referring to a timing chart.

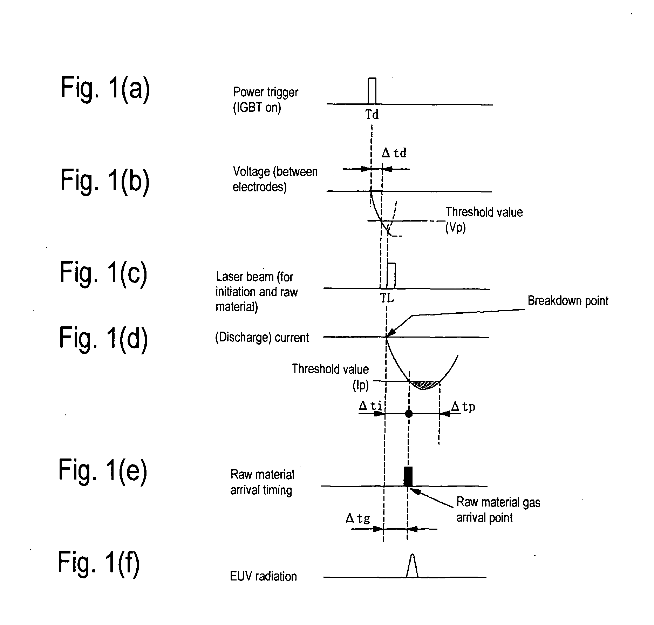

Fig. 1 is a timing chart explaining the method of EUV generation according to the present invention.

First, a trigger signal is input to a switching means (e.g., IGBT) of a pulsed power generator used for applying pulsed power between a pair of electrodes (time: Td) to turn the switching means on (Fig. 1 (a)). After $\Delta td$, a voltage between the electrodes reaches a threshold value Vp (Fig. 1(b)).

The threshold value Vp is a voltage value at a time when the value of the discharge current, which flows at the time of the generation of an electric discharge, reaches at least a threshold value Ip (as described below). In other words, the peak value of the discharge current does not reach the threshold value Ip if discharge occurs below the threshold value Vp.

Supposing no discharge occurs, a voltage between the electrodes reaches the maximal value and is maintained there (See the broken line in Fig. 1(b)).

A laser beam irradiates the discharge area at a point of time TL at or after a point of time (Td + $\Delta td$) at which the voltage between the electrodes has reached the threshold value Vp (Fig. 1(c)).

Electric discharge starts. After $\Delta ti$, a discharge current value reaches the aforementioned threshold value Ip (Fig. 1(d)).

The threshold value Ip is the lower limit of the discharge current value needed for generating EUV radiation of a specified intensity. A period during which the discharge current value corresponds at least to the threshold value Ip is $\Delta tp$.

During the period $\Delta tp$ after a point of time (TL + $\Delta ti$), at least part of the high temperature plasma raw material that was vaporized by a laser beam, which had been irradiated to the high temperature plasma raw material after passing through the discharge area, spreading at a specific speed and having a specified spatial density distribution, reaches the discharge area, resulting in the emission of EUV radiation (Figs. 1(e) & 1(f)).

Here, a delay time between a point of time at which the laser beam irradiates the discharge area and a point of time at which the laser beam irradiates the high temperature plasma raw material can be regarded as substantially the same because it is extremely small. Accordingly, a point of time at which the laser beam irradiates the high temperature plasma raw material is TL like a point of time at which a laser beam irradiates the discharge area.

Given that a period between a point of time at which the laser beam irradiates the raw material and a point of time at which at least part of the vaporized raw material having a specified spatial density distribution reaches the discharge area is $\Delta tg$, the following relationship is established (Fig. 1(e)):

$$TL + \Delta ti \leq TL + \Delta tg \leq TL + \Delta ti + \Delta tp$$

(2) The relationship between the position of the electrodes, the position of the raw material supply and the radiating position of the energy beam

In the EUV light source device according to the present invention, as described above, the same laser beam allows supplying vaporized raw material to the discharge area, starting electric discharge and defining the discharge area. A description of the positional relationship is given below.

As an example, high temperature plasma raw material, which is a target for the laser beam, is added drop-wise as droplets. However, the method of supplying high temperature plasma raw material is not limited to this. Wire-shaped high temperature plasma raw material may be used, for example.

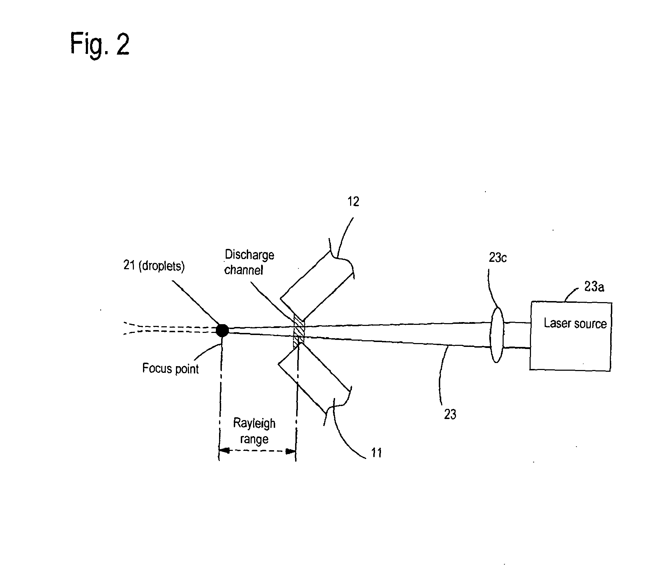

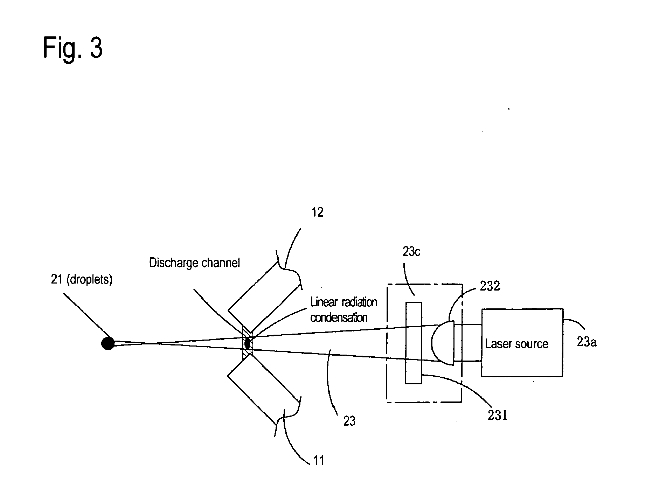

Figs. 2 & 3 are schematic block diagrams explaining the aforementioned relationship. In the drawings, a pair of plate-like electrodes 11, 12 is arranged at a specified interval. A discharge area is located in the gap between the electrodes. High temperature plasma raw material 21 is supplied by a raw material supply unit (not shown here) to the space between the pair of electrodes and extreme ultraviolet radiation collector optics (EUV radiation collector optics as used herein; not shown here) in the gravitational direction relative to the vicinity of the discharge area.

The EUV light source device according to the present invention is configured in such a way that a laser beam emitted from a laser source passes through the discharge area between the first electrode 11 and the second electrode 12 and irradiates the high temperature plasma raw material 21.

Fig. 2 shows an example of focusing a laser beam 23 on a point by a radiation condensing optical system 23c. As the radiation condensing optical system 23c, a convex lens may be used, for example. Electrodes are exemplified by a pair of rotary electrodes. If the intensity of the focused laser beam 23, which passes through the discharge area, is relatively high, insulation breakdown is induced between the electrodes 11, 12. As a result, a discharge channel is fixed in a space containing the optical axis of the laser beam 23.

At a time when the laser beam 23, which has passed through the discharge area, irradiates the high temperature plasma raw material 21 at a specific intensity of radiation condensation, the high temperature plasma raw material is vaporized. The vaporized high temperature plasma raw material spreads centering on the normal direction of the surface of the high temperature plasma raw material on which the laser beam 23 was incident.

Since the laser beam 23 passes through the discharge area and irradiates the high temperature plasma raw material 21, the radiation position is on the surface of the high temperature plasma raw material facing the discharge area. As a result, the vaporized high temperature plasma raw material spreads in the direction of the discharge area.

Here, EUV radiation of a specific intensity can be generated if at least part of the vaporized high temperature plasma raw material reaches the discharge area, and the discharge current reaches a specified value while the high temperature plasma raw material having a specified spatial density distribution exists in the discharge area.

In other words, EUV radiation of a specified intensity can be generated by properly setting the timing of the laser beam 23 passing through the discharge area, the timing of the laser beam being radiated onto the high temperature plasma raw material 21, the intensity of focusing the laser beam 23 in the discharge area, the energy of the laser beam at a position at which it irradiates the high temperature plasma raw material 21, the direction of the laser beam to be radiated and the positional relationship between the discharge area and the high temperature plasma raw material.

Moreover, since a discharge channel is fixed in the space containing the optical axis of the laser beam, the positional stability of the originating point of EUV radiation can be enhanced.

In the embodiment as shown in Fig. 2, it is possible to achieve an arrangement in which there is no significant difference between the intensity of the focused laser beam in the discharge area and the intensity of the focused laser beam on the high temperature plasma raw material using a radiation condensing optical system having a relatively long focal length.

As an example, the focal position of the laser beam is placed on the high temperature plasma raw material, and the Rayleigh range of the radiation condensing optical system is made to be a distance between the center of the discharge area and the center of the high temperature plasma raw material. Needless to say, the direction at which the laser beam is radiated and the energy thereof may be properly set in this case as well.

Fig. 3 shows an example of linearly focusing a laser beam by a radiation condensing optical system 23c. As the radiation condensing optical system 23c, two cylindrical lenses 231, 232 may be used, for example. Two cylindrical lenses 231, 232 in Fig. 3 are arranged in such a way that the axial focusing directions of the laser beam 23 are orthogonal to each other.

Like the example of arrangement as shown in Fig. 2, Fig. 3 shows an example of arrangement in an EUV light source device in which the laser beam 23 emitted from a laser source 23a passes through a first rotary electrode 11 and a second rotary electrode 12 to irradiate the high temperature plasma raw material 21.

In the example of arrangement as shown in Fig. 3, insulation breakdown is also induced between the electrodes 11, 12, if the intensity of the focused laser beam passing through the discharge area is relatively high. Specifically, the position of the discharge channel is fixed on the radiation condensing line of the laser beam 23 by linearly focusing the laser beam 23 to a specified position in the discharge area in the vicinity of the electrodes. Since the laser beam 23 passes through the discharge area and irradiates the high temperature plasma raw material 21, the vaporized high temperature plasma raw material spreads in the direction of the discharge area, as mentioned above.

EUV radiation of a specific intensity can be generated if at least part of the vaporized high temperature plasma raw material reaches the discharge area, and the discharge current reaches a specified value while the high temperature plasma raw material having a specified spatial density distribution exists in the discharge area.

In other words, like the example of the arrangement shown in Fig. 2, EUV radiation of a specified intensity can be generated by properly setting the timing of the laser beam 23 passing through the discharge area, the timing of the laser beam being irradiated to the high temperature plasma raw material 21, the intensity of the focused laser beam 23 in the discharge area, the energy of the laser beam at a position at which it irradiates the high temperature plasma raw material 21, the direction of the laser beam and the positional relationship between the discharge area and the high temperature plasma raw material.

Moreover, since the discharge channel is fixed on the radiation condensing line of the laser beam, the positional stability of the originating point of EUV radiation can be enhanced.

As shown in Fig. 3, the curvatures of the two cylindrical lenses 231, 232, which are arranged in such a way that the axial focusing directions of the laser beam 23 are orthogonal to each other, may be different. Such a configuration of two cylindrical lenses allows the laser beams 23 to become long and narrow in the direction of discharge in the discharge area and to be focused to a relatively round-shaped small spot on the raw material. Accordingly, the discharge channel can be defined and vaporized raw material be supplied to the discharge area efficiently. Needless to say, the direction of the laser beam and energy thereof may be properly set in this case as well.

(3) Energy of the energy beam

In Fig. 1, $\Delta$tg, which is a period between a point of time at which the laser beam irradiates the raw material and a point of time at which at least part of the vaporized raw material having a specified spatial density distribution reaches the discharge area, can be found based on the distance between the discharge area and the raw material onto which the laser beam is irradiated and the speed at which vaporized high temperature plasma raw material spreads. Here, the distance between the discharge area and the high temperature plasma raw material onto which the laser beam is irradiated depends on the position of the raw material at the time of the irradiation of the laser beam and the direction of irradiation with the laser beam onto the high temperature plasma raw material.

As described above, the high temperature plasma raw material vaporized by laser beam irradiation spreads at a specific speed centering on the normal direction of the surface of the high temperature plasma raw material on which the laser beam is incident. The aforementioned specific speed depends on the energy of the laser beam irradiated onto the raw material.

In other words, $\Delta$tg, which is the period between a point of time at which the laser beam irradiates the raw material and a point of time at which at least part of the vaporized raw material having a specified spatial density distribution reaches the discharge area, depends on the positions of the discharge area and the raw material, the direction of irradiating the laser beam onto the raw material and the energy of the laser beam to be irradiated and can be set to a specified time by properly setting these parameters.

In short, EUV radiation of a specified intensity can be generated by setting the positions of the discharge area and the raw material, the direction of irradiating the laser beam onto the raw material, the energy of the laser beam to be irradiated and the timing of irradiating the laser beam in such a way that the following relationship can be established.

$$Td + \Delta td \leq TL \qquad (26)$$

$$TL + \Delta ti \leq TL + \Delta tg \leq TL + \Delta ti + \Delta tp \qquad (27)$$

Also, the positional stability of the originating point of EUV radiation can be enhanced.

In the present invention, the aforementioned problems can be solved by the following ways:

(1) An extreme ultraviolet light source device comprises a vessel, a raw material supply unit for supplying liquid or solid raw material for generating extreme ultraviolet radiation inside the vessel, an energy beam irradiation means for irradiation of an energy beam to vaporize the raw material, a pulsed power generator for supplying pulsed power to a pair of electrodes placed at a specified interval in order to generate high temperature plasma by heating and exciting the vaporized raw material using discharge in the vessel, collector optics for collecting extreme ultraviolet radiation irradiated from the high temperature plasma generated in a discharge area of the discharge generated by the pair of electrodes, an extreme ultraviolet radiation extracting area for extracting the collected extreme ultraviolet radiation, wherein the energy beam irradiation means allows irradiating an energy beam to the raw material supplied in a space which is outside the discharge area and allows the vaporized raw material to reach the discharge area, via the gap between the electrodes to which power is applied. The energy beam irradiation means starts discharge inside the discharge area by the energy beam passing through the gap between the electrodes to which power is applied and defines a discharge channel at a specified position in the discharge area.

(2) In the aforementioned (1), the timing of the energy beam passing through the discharge area, the timing of the energy beam being irradiated to the high temperature plasma raw material, the energy of the energy beam in the discharge area, the energy of the energy beam at a position at which it irradiates the high temperature plasma raw material, the direction of the energy beam to be irradiated and the position of the high temperature plasma raw material to be supplied relative to the discharge area are set in advance in such a way that the discharge current generated in the discharge area can exceed a specified threshold value at a time that at least part of the vaporized raw material, which has a specific spatial density distribution, reaches the discharge area after the energy beam was emitted from the energy beam irradiation means.

(3) In the aforementioned (1) and (2), the raw material is supplied by the raw material supply means by providing the raw material in the form of droplets and supplying them drop-wise in the gravitational direction.

(4) In the aforementioned (1) and (2), the raw material is supplied by the raw material supply means by making the raw material linear and moving the linear material continuously.

(5) In the aforementioned (1) and (2), the raw material supply means comprises a raw material supply disc, wherein the raw material is supplied by the raw material supply means by making the raw material liquid, supplying the liquid material to the raw material supply disc, and then, moving the liquid raw material supply unit of the raw material supply disc to the irradiation position of the energy beam by rotating the raw material supply disc to which the liquid material is supplied.

(6) In the aforementioned (1) and (2), the raw material supply means comprises a capillary, wherein the raw material is supplied by the raw material supply means by making the raw material liquid and supplying the liquid material to the irradiation position of the energy beam via the capillary.

(7) In the aforementioned (1) and (2), a tubular nozzle is provided at the irradiation position of the energy beam, wherein at least part of the raw material vaporized by the energy beam is sprayed out of the tubular nozzle.

(8) In the aforementioned (7), a constricted area is provided within part of the tubular nozzle.

(9) In the aforementioned (1), (2), (3), (4), (5), (6), (7) and (8), a magnetic field application means is further provided for applying a magnetic field to the discharge area substantially in parallel to the direction of discharge generated between the pair of the electrodes.

(10) In the aforementioned (1), (2), (3), (4), (5), (6), (7), (8) and (9), the pair of electrodes are disc-shaped and rotated in such a way that the discharge generating position on the surface of the electrodes changes.

(11) In the aforementioned (10), the pair of the disc-shaped electrodes face each other with a specified distance between the edges of the peripheral portions thereof.

(12) In the aforementioned (1), (2), (3), (4), (5), (6), (7), (8), (9), (10) and (11), the energy beam is a laser beam.

(13) A method of generating extreme ultraviolet radiation by irradiating liquid or solid raw material with an energy beam, which is used for emitting extreme ultraviolet radiation and supplied to a vessel containing a pair of electrodes, such that the raw material is vaporized, generating high temperature plasma by heating and exciting the vaporized raw material using discharge from the pair of electrodes and thus generating extreme ultraviolet radiation, wherein the energy beam irradiates the raw material supplied to a space which is outside the discharge area and allows the vaporized raw material to reach the discharge area, wherein discharge is started in the discharge area by a laser beam passing through the gap between the electrodes to which power is applied and wherein a discharge channel is fixed to a specified position in the discharge area.

(14) In the aforementioned (13), the timing of the energy beam passing through the discharge area, the timing of the energy beam being irradiated to the high temperature plasma raw material, the energy level of the energy beam in the discharge area, the energy of the energy beam at a position at which it irradiates the high temperature plasma raw material, the direction of the energy beam and the position of the high temperature plasma raw material to be supplied relative to the discharge area are set in advance in such a way that the discharge current generated in the discharge area can exceed a specified threshold value at a time at which at least part of the vaporized raw material, which has a specified spatial density distribution, reaches the discharge area after the energy beam was emitted.

(15) In the aforementioned (14), time data on discharge start timing and time data on a point of time at which the discharge current reaches a specified threshold value are generated, wherein the irradiation timing of an energy beam is corrected based on both time data.

(16) In the aforementioned (14) and (15), an energy beam irradiates the raw material one or more times while discharge by a pair of electrodes is stopped in advance of the irradiation of an energy beam for which the irradiation timing is set as described above.

The present invention can provide the following effects.

(1) In part because electric discharge starts by radiation with an energy beam to define the position of the discharge channel in the discharge area, and in part because the discharge current value reaches a specified value after discharge in the discharge channel at a position which has been defined, while the raw material maintains a specified spatial density distribution, EUV radiation can be achieved efficiently. Moreover, since the discharge channel is fixed on the radiation condensing line of the laser beam, the positional stability of the originating point of EUV radiation can be enhanced.

(2) Since the timing of the energy beam passing through the discharge area, the timing of the energy beam irradiating the high temperature plasma raw material, the energy level of the energy beam in the discharge area, the energy level of the energy beam at a position at which it irradiates the high temperature plasma raw material, the direction of the energy beam and the position of the high temperature plasma raw material to be supplied relative to the discharge area are set in advance in such a way that the discharge current generated in the discharge area can exceed a specified threshold value at a time from when the energy beam is emitted from the energy beam irradiation means at which at least part of the vaporized raw material, which has a specified spatial density distribution, reaches the discharge area, EUV radiation can be achieved efficiently.

(3) By providing a magnetic field application means for the discharge area substantially in parallel to the direction of discharge generated between a pair of electrodes, the size of high temperature plasma for emitting EUV radiation can be made small, thus lengthening the time of EUV radiation.

(4) By making the pair of electrodes disc-shaped and rotating them so that the position on the surfaces of electrodes at which discharge is generated can be changed, the wear of the electrodes can be slowed, whereby the service life of electrodes can be lengthened.

(5) By generating time data on discharge start timing and time data on a point of time at which the discharge current reaches a specified threshold value and correcting the timing of the irradiating energy beam based on both time data, efficient EUV radiation can be achieved.

Moreover, even if the operation of a semiconductor switching element, such as IGBT used as a solid switch SW (i.e., a switching means of a pulsed power generator) varies, efficient EUV radiation can be achieved.

(6) The irradiation of an energy beam to the raw material one time or more while discharge by a pair of electrodes is stopped, in advance of irradiation by the energy beam for which the irradiation timing is set, makes it easier to generate discharge between the electrodes, which allows generating of discharge at a desired timing.

First Embodiment

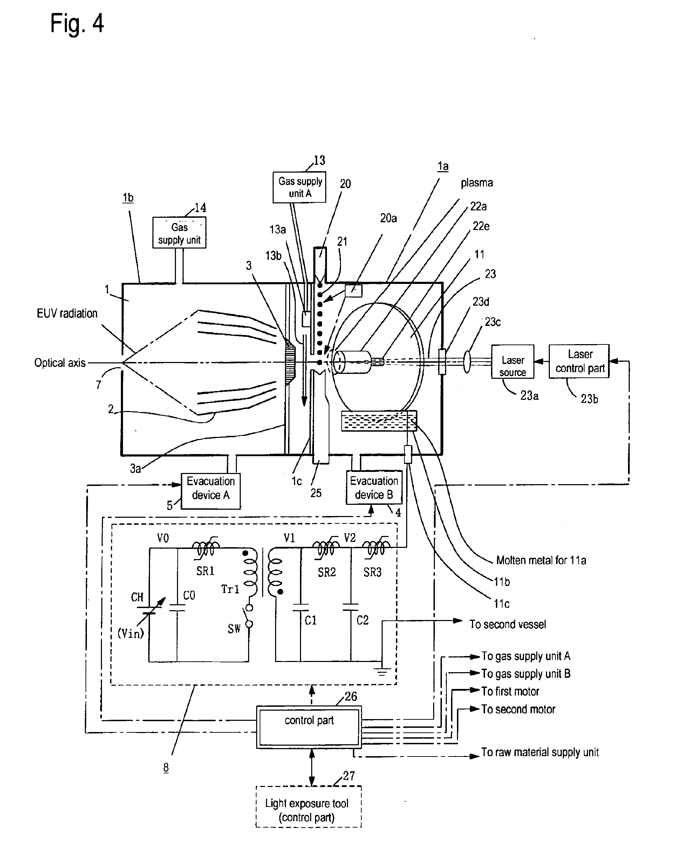

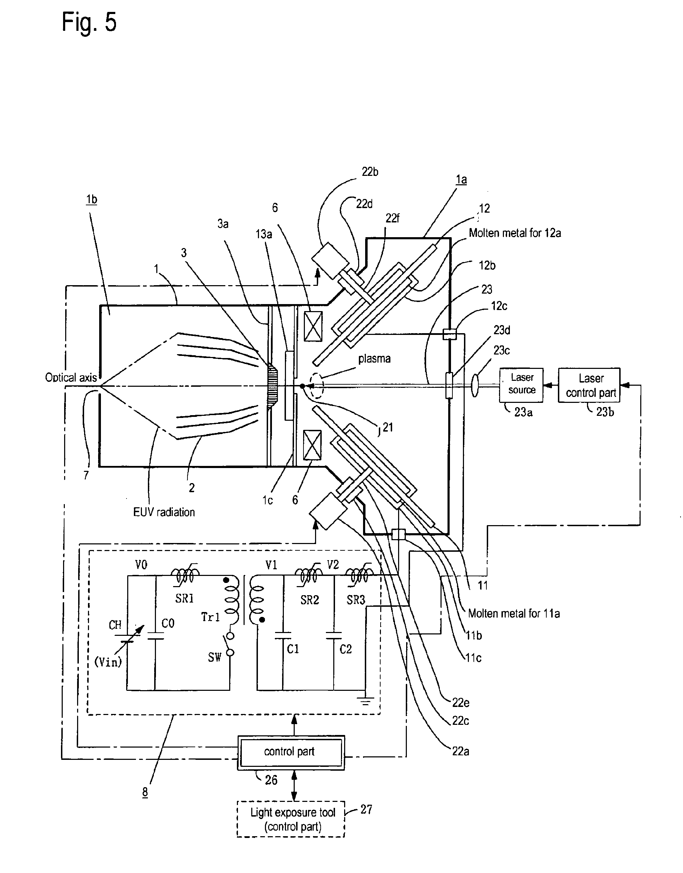

Figs. 4 & 5 show the configuration (a sectional view) of the extreme ultraviolet (EUV) light source device according to the present invention. Fig. 4 is a front view of the EUV light source device according to the present invention. EUV radiation is extracted from the left side in the drawing. Fig. 5 is a top view of the EUV light source device according to the present invention.

The EUV light source device in Figs. 4 & 5 has a chamber 1, which is a discharge vessel. The chamber 1 is essentially divided into two spaces by a barrier 1c having an opening. In one space a discharge part is located. The discharge part is a heating and excitation means for heating and exciting a high temperature plasma raw material containing an EUV radiating species. The discharge part comprises a pair of electrodes 11, 12.

On the other space are provided EUV radiation collector optics 2 for collecting EUV radiation emitted from the high temperature plasma, which was generated by heating and exciting high temperature plasma raw material, and guiding it to a illumination optical system of a lithography tool (not shown here) via an EUV extracting part 7 provided in the chamber 1 and a debris trap for preventing debris created as a result of the generation of plasma by electric discharge from moving into the EUV radiation collector part. In the present embodiment, the debris trap consists of a gas curtain 13b and a foil trap 3 as shown in Fig. 4 and Fig. 5.

As used herein, the space in which the discharge part is placed is referred to as the discharge space 1a and the space in which the EUV radiation collector optics is placed as the EUV radiation collecting space 1b.

An evacuation device 4 is connected to the discharge space 1a. The evacuation device 5 is connected to the EUV radiation collecting space 1b. The foil trap 3 is held inside the EUV radiation collecting space in the chamber 1 using a foil trap holding barrier 3a, for example. That is, as shown in Figs. 4 & 5, the EUV radiation collecting space 1b is divided into two spaces by the foil trap holding barrier 3a.

In Figs. 4 & 5, the discharge part appears larger than the EUV radiation extracting part. However, this is only to make the explanation easier. The actual size is different from that in Figs. 4 & 5. In fact, the EUV radiation collecting part is larger than the discharge part. That is, the EUV radiation collecting space 1b is larger than the discharge space 1a.

A description of each part of the EUV light source device according to the present embodiment and the operation thereof is given below.

(1) Discharge part

The discharge part consists of a first discharge electrode 11, which is a disc-shaped metal body, and a second discharge electrode 12, which is also a disc-shaped metal body. The first and second discharge electrodes 11, 12, respectively, are made of high melting metal such as tungsten, molybdenum and tantalum and placed facing each other at a specified interval. Of these two electrodes 11, 12, either one is the electrode on the ground side and the other one the electrode on the high voltage side.

The surfaces of the electrodes 11, 12 may be arranged on the same plane. However, as shown in Fig. 5, it is preferable to arrange the electrodes in such a way that the edges of the peripheral portions, where the electric field is concentrated at the time of the application of power, face each other at a specified interval so that electric discharge can easily occur. In other words, it is preferable to arrange the electrodes in such a way that the virtual planes containing the surfaces of the electrodes cross each other. The specified interval signifies an interval that is the shortest between the edges of the peripheral portions of the electrodes.

As described below, electric discharge occurs on the edges of the peripheral portions of the electrodes at a time when pulsed power is applied to the electrodes 11, 12 from a pulsed power generator 8. In general, much discharge occurs at a place where the interval between the edges of the peripheral portions of the electrodes 11, 12 is the shortest.

Supposing the surfaces of both electrodes 11, 12 are arranged on the same plane, the aforementioned specified interval is one at a place where the interval between the side faces of electrodes is the shortest. In this case, the starting position of discharge is on the virtual contact line formed by the contact between the side face of a disc-shaped electrode and a virtual plane perpendicular to the side face. Discharge may occur at any place on the virtual contact line of each electrode. Accordingly, the discharge position may not be stable if the surfaces of both electrodes are arranged on the same plane.

By contrast, as shown in Fig. 5, the discharge position becomes stable if the electrodes are arranged in such a way that the edges of the peripheral portions of the electrodes 11, 12 are placed at a specified interval facing each other since much discharge occurs at a place where the interval between the edges of the peripheral portions of the electrodes 11, 12 is the shortest, as described above. As used herein, the space between the electrodes where discharge occurs is referred to as a discharge area.

If the electrodes are arranged in such a way that the edges of the peripheral portions of the electrodes 11, 12 are placed at a specified interval facing each other as shown in Fig. 5, both electrodes are radially arranged centering on the place where virtual planes containing the surfaces of the first and second electrodes 11, 12, respectively, cross each other if they are seen from the top as shown in Fig. 5. In Fig. 5, the portions where an interval between the edges of the peripheral portions of both radially arranged electrodes is the longest are located on the opposite side of the EUV radiation collector optics (as described below) relative to the position where the aforementioned virtual planes cross each other.

Here, it is possible to arrange the portions where an interval between the edges of the peripheral portions of both radially arranged electrodes is the longest on the same side as the EUV radiation collector optics 2 relative to the position where the aforementioned virtual planes cross each other. In this case, however, the interval between the discharge area and the EUV radiation collector optics 2 becomes too long to be practical because the EUV radiation collecting efficiency declines.

The EUV light source device according to the present embodiment uses EUV radiation emitted from high temperature plasma, which was generated by discharge current drive from high temperature plasma raw material vaporized by irradiation with a laser beam. A means of heating and exciting high temperature plasma raw material is high current by discharge generated between a pair of electrodes 11, 12. Hence, a large thermal load is placed on the electrodes 11, 12 as a result of the discharge. Since high temperature plasma occurs in the vicinity of the discharge electrodes, the thermal load originating from the plasma is also placed on the electrodes 11, 12. Thus, the electrodes are gradually abraded by such thermal loads and give rise to metal debris.

If it is used as the light source device of a lithography tool, the EUV radiation device collects EUV radiation emitted from high temperature plasma using the EUV radiation collector optics 2 and emits the collected EUV radiation toward the side of the lithography tool. As a result, metal debris causes damage to the EUV radiation collector optics 2, thereby deteriorating the EUV radiation reflectivity of the EUV radiation collector optics 2.

Moreover, the gradual abrasion of the electrodes 11, 12 changes the shape of the electrodes. As a result, discharge generated between the pair of the electrodes 11, 12 gradually becomes unstable, resulting in the instability of the generation of EUV radiation. If the aforementioned hybrid type EUV light source device is used as a light source for a mass production type semiconductor lithography tool, it is necessary to prevent the aforementioned abrasion of the electrodes in order to lengthen the service life of the electrodes as much as possible.

In order to satisfy such requirements, the EUV light source device as shown in Figs. 4 & 5 has disc-shaped first and second electrodes 11, 12, respectively, which are rotated at least at the time of discharge. By rotating the first and second electrodes 11, 12, respectively, the position between the electrodes where pulse discharge is generated changes for each pulse. As a result, a thermal load placed on the first and second electrodes 11, 12, respectively, becomes small, whereby the abrasion speed of the electrodes 11, 12 declines and the service life thereof increases. As used herein, the first electrode 11 and the second electrode 12 may be referred to as the first rotary electrode and the second rotary electrode, respectively.

Specifically, the rotary axis 22e of a first motor 22a and the rotary axis 22f of a second motor 22b are mounted substantially on the central portion of the first disc-shaped rotary electrode 11 and the second disc-shaped rotary electrode 12, respectively. The first motor 22a and the second motor 22b allow rotating the rotary axis 22e and the rotary axis 22f, respectively, so that the first rotary electrode 11 and the second rotary electrode 12 can be rotated, respectively. Here, the rotary direction is not specified. The axes of rotation 22e, 22f are introduced into the chamber 1 via mechanical seals 22c, 22d, respectively. The mechanical seals 22c, 22d allow the axes of rotation to be rotated while keeping the chamber 1 under reduced pressure.

As shown in Fig. 4, part of the first rotary electrode 11 is immersed in a first conductive container 11b containing conductive molten metal for power supply 11a. Likewise, part of the second rotary electrode 12 is immersed in a second conductive container 12b containing conductive molten metal for power supply 12a.

The first container 11b and the second container 12b are connected to a pulsed power generator 8, which functions as a supply means for pulsed power, via power introduction parts 11c, 12c, respectively, that have insulating properties and can keep the chamber 1 under reduced pressure. As described above, in part because the first and second containers 11b, 12b, respectively, and the molten metal for power supply 11a, 12a are conductive and in part because part of the first rotary electrode 11 and part of the second rotary electrode 12 are immersed in the aforementioned molten metal for power supply 11a, 12a, respectively, pulsed power can be applied between the first rotary electrode 11 and the second rotary electrode 12 by applying pulsed power to the gap between the first container 11b and the second container 12b using the pulsed power generator 8.

As the molten metal for power supply 11a, 12a, a metal is used that has no influence on EUV radiation at the time of discharge. The molten metal for power supply 11a, 12a also functions as cooling means for the discharge portions of the rotary electrodes 11, 12, respectively. The first container 11b and the second container 12b are provided with temperature adjustment means (not shown here) for maintaining the molten metal in the molten state.

(2) Discharge startup mechanism

The EUV light source device according to the present embodiment is provided with a laser source 23a for issuing the laser beam 23 used to irradiate the high temperature plasma raw material and a specified position of the discharge area and a laser control part 23b for controlling the operation of the laser source 23a. As described above, since the electrodes are arranged in such a way that the edges of the peripheral portions of the rotary electrodes 11, 12 face each other at a specified interval, most discharge occurs at a position where the interval between the edges of the peripheral portions of the electrodes 11, 12 is the shortest. Thus, the discharge position becomes stable. However, the stability of the discharge position declines if the edges are deformed by abrasion as a result of discharge.

At a time when the laser beam 23 is focused on a specified position of the discharge area, conductivity declines in the vicinity of the focal point of the laser beam due to electron emission. Hence, the position of a discharge channel is fixed to the position where the focal point of the laser beam is set. As a result, the positional stability of the starting point of EUV radiation is enhanced.

The laser source 23a for emitting the laser beam 23 includes a carbon dioxide gas laser source, solid laser sources, such as a YAG laser, a $YVO_4$ laser and a YLF laser and excimer laser sources, such as an ArF laser, a KrF laser and a XeCl laser.

In the present embodiment, a laser beam is used as an energy beam to irradiate a specified place in the discharge area. However, an ion beam or an electron beam may be used to irradiate the high temperature plasma raw material in place of a laser beam.

Fig. 2 shows an example of converging radiation to a point using a convex lens having a relatively long focal length. By focusing the laser beam 23 to a point at a specified place in the discharge area in the vicinity of the electrodes 11, 12, insulation breakdown is induced between the electrodes 11, 12. Here, conductivity is down in the vicinity of the focal point of the laser beam (i.e., a radiation condensing point) due to electron emission. Accordingly, the position of a discharge channel is fixed to the position where the radiation condensing point of the laser beam is set.

Fig. 3 shows an example of linearly condensing radiation by two cylindrical lenses 231, 232. These two cylindrical lenses 231, 232 are arranged in such a way that the axial directions of convergence of the laser beam are orthogonal to each other.

Thus, by linearly condensing the laser beams 23 on a specified position in the discharge area in the vicinity of the electrodes 11, 12, insulation breakdown is induced between the electrodes 11, 12. Like the focusing of radiation, the position of a discharge channel is fixed on the radiation condensation line of a laser beam.

That is, by fixing the position of linearly condensing radiation by irradiating a laser beam, the position of a discharge channel is fixed to a local range in the discharge area. As a result, the positional stability of the originating point of EUV radiation is enhanced.

(3) Pulsed power generator

The pulsed power generator 8 allows applying pulsed power of a short pulse width to the gap between the loads, that is, the first container 11b and second container 12b (i.e., the first rotary electrode 11 and second rotary electrode 12), via a magnetic pulse compression circuit part which is comprised of capacitors and magnetic switches. Figs. 4 & 5 show one example of the configuration of the pulsed power generator.

The pulsed power generator in Figs. 4 & 5 has two magnetic pulse compression circuits using two magnetic switches SR2, SR3 constituted by saturatable reactors. These two magnetic pulse compression circuits are formed of a capacitor C1, a first magnetic switch SR2, a capacitor C2 and a second magnetic switch SR3.

The magnetic switch SR1 is used for reducing switching loss at a solid switch SW, such as IGBT, which is a semiconductor switching element, and is also referred to as a magnetic assist. The solid switch SW is the aforementioned switching means and, therefore, may be referred to as a switching means below.

A description of the configuration of the circuit and the operation thereof is given below by referring to Fig. 4 and Fig. 5. First, the charging voltage of a charger CH is adjusted to a specified value Vin, and a main capacitor C0 is charged by the charger CH. At that time, the solid switch SW (e.g., IGBT) is off.

At a time when the solid switch SW is turned on after the completion of charging the main capacitor C0, the voltage applied to both ends of the solid switch SW is mainly applied to both ends of the magnetic switch SR1.

At a time when a time integration value of the charging voltage V0 of the main capacitor C0 applied to both ends of the magnetic switch SR1 reaches a limit value determined by the characteristics of the magnetic switch SR1, the magnetic switch SR1 is saturated, the magnetic switch is turned on and then current flows in a loop constituted of the main capacitor C0, the magnetic switch SR1, the primary side of a booster transformer Tr1 and the solid switch SW. At the same time, current flows in a loop constituted of the secondary side of the booster transformer Tr1 and the capacitor C1. As a result, the electric charge stored in the main capacitor C0 is transferred to and charged in the capacitor C1.

Subsequently, at a time when a time integration value of a voltage V1 in the capacitor C1 reaches a limit value determined by the characteristics of the magnetic switch SR2, the magnetic switch SR2 is saturated, the magnetic switch is turned on and then current flows in a loop constituted of the capacitor C1, the magnetic switch SR2 and the capacitor C2. As a result, the electric charge stored in the main capacitor C1 is transferred to and charged in the capacitor C2.

After that, at a time when a time integration value of a voltage V2 in the capacitor C2 reaches a limit value determined by the characteristics of the magnetic switch SR3, the magnetic switch SR3 is saturated, the magnetic switch is turned on and then a high voltage pulse is applied to the gap between the first rotary electrode and the second rotary electrode.

If the inductance of two capacity transition type circuits, constituted by magnetic switches SR2, SR3 and capacitors C1, C2, is set in such a way as to decrease on the latter stage, the pulse compression is carried out in such a way that the width of current pulses flowing in each stage becomes narrow in the latter stage. As a result, it is possible to achieve intensive discharge of short pulses between the first rotary electrode and the second rotary electrode, whereby the energy supplied to the plasma also increases.

(4) Raw material supply and material vaporization mechanism

High temperature plasma raw material 21 used for emitting extreme ultraviolet radiation is supplied to the vicinity of a discharge area (i.e., the space between the edge of the peripheral portion of the first rotary electrode 11 and the edge of the peripheral portion of the second rotary electrode 12 where discharge occurs) in the liquid or solid state from the raw material supply unit 20 provided for the chamber 1. Specifically, high temperature plasma raw material 21 is supplied to the space that is outside the discharge area and allows vaporized high temperature plasma raw material to reach the discharge area.

The aforementioned raw material supply unit 20 is provided on the upper wall of the chamber 1, for example. High temperature plasma raw material 21 is made into droplets and supplied (drop-wise) to the space in the vicinity of the aforementioned discharge area. The supplied droplets of the high temperature plasma raw material 21 are vaporized by being irradiated by the laser beam emitted from the laser source 23a at a time when it reaches the space in the vicinity of the discharge area.

As described above, the high temperature plasma raw material vaporized by irradiation with the laser beam 23 spreads in the normal direction of the surface of high temperature plasma raw material on which the laser beam 23 is incident. Here, part of the high temperature plasma raw material supplied to the discharge area, which was vaporized by irradiation with the laser beam 23 and does not contribute to the formation of high temperature plasma, or part of clusters of atomic gas decomposed as a result of the formation of plasma is brought into contact with and accumulated on the low-temperature portions of the EUV light source device as debris.

The laser beam 23 is irradiated from the side of the discharge electrodes 11, 12 in order to irradiate not only high temperature plasma raw material 21 but also a specified position in the discharge area. Accordingly, the vaporized high temperature plasma raw material spreads in the direction of the discharge electrodes 11, 12 (i.e., in the direction of the discharge area); therefore it is possible to prevent debris from advancing toward the EUV radiation collector optics 2.

As described above, the high temperature plasma raw material vaporized by irradiation with the laser beam 23 spreads in the normal direction of the surface of high temperature plasma raw material on which the laser beam 23 is incident. More specifically, the density of the high temperature plasma raw material, which was vaporized by irradiation with the laser beam 23 and scattered around, is the highest in the aforementioned normal direction and declines as the angle from the aforementioned normal direction increases.

Accordingly, the position of high temperature plasma raw material 21 to be supplied to the discharge area and the conditions of irradiation with the laser beam 23, such as the irradiation energy, are properly set in such a way that a spatial density distribution of vaporized high temperature plasma raw material to be supplied to the discharge area meets the conditions required for collecting EUV radiation efficiently after the heating and excitation of high temperature plasma raw material in the discharge area.

A material recovery means 25 may be provided beneath the space to which high temperature plasma raw material is supplied in order to recover high temperature plasma raw material that was not vaporized.

(5) EUV radiation collecting part

EUV radiation emitted from the discharge part is collected by grazing incidence type EUV radiation collector optics 2 provided in the EUV radiation collecting part and guided to the illumination optical system of a lithography tool (not shown here) via the EUV radiation extracting part 7 provided for the chamber 1.

In general, the grazing incidence type EUV radiation collector optics 2 have a structure formed by arranging a plurality of nested thin concave mirrors with high precision. The shape of the reflecting surface of each concave mirror is spheroid, paraboloid or Walter type. Each concave mirror is a rotation body. Here, the Walter type means a concave shape having a radiation incidence surface constituted of a hyperboloid of revolution and a spheroid or hyperboloid of revolution and paraboloid in the sequential order from the radiation incidence side

The basic material of the aforementioned concave mirrors is nickel (Ni), for example. Since EUV radiation having a very short wavelength needs to be reflected, the reflecting surface of a concave mirror is considerably smooth. The reflecting material provided for the smooth surface is a metal film made of ruthenium (Ru), molybdenum (Mo) or rhodium (Rh). On the reflecting surface of each concave mirror, such a metal film is compactly coated. The EUV radiation collector optics having the aforementioned configuration allows reflecting and condensing EUV radiation of 0 to 25 degrees in grazing incidence angle well.

Between the aforementioned discharge part and EUV radiation collecting part is placed, a debris trap for capturing debris, such as metal powder, generated by the sputtering of high temperature plasma on the peripheral portions of the first and second rotary electrodes 11, 12, respectively, which contact high temperature plasma generated after discharge, and debris originated from an EUV radiating species in high temperature plasma raw material, such as Sn or Li, in order to prevent damage to the EUV radiation collector optics 2. In the EUV light source device according to the present embodiment in Figs. 4 & 5, as described above, the debris trap consists of a gas curtain 13b and a foil trap 3.

As shown in Fig. 4, the gas curtain 13b is constituted by gas supplied from a gas supply unit 13 to the chamber 1 via a nozzle 13a. The nozzle 13a is rectangular, and an opening from which gas is emitted has a long and narrow quadrangle shape. After gas is supplied to the nozzle 13a from the gas supply unit 13, sheet-shaped gas is emitted from the opening of the nozzle 13a to form the gas curtain 13b. The gas curtain 13b changes the traveling direction of debris to prevent debris from reaching the EUV radiation collector optics 2.

Gas used for the gas curtain 13b is preferably one having a high transmittance for EUV radiation including rare gas, such as helium (He) or argon (Ar), and hydrogen ($H_2$).

Moreover, a foil trap 3 is provided between the gas curtain 13b and the EUV radiation collector optics 2. The foil trap 3 is also described in Japanese Unexamined Patent Publication No. 2004-214656 and corresponding U.S. Patent 7,247,866 as "a foil trap." The foil trap 3 comprises multiple plates arranged in the radial direction of a high-temperature generation area and a ring-shaped support element supporting those plates in such a way as to not block EUV radiation emitted from high temperature plasma.

By providing such a foil trap 3 between the gas curtain 13b and the EUV radiation collector optics 2, pressure increases between high density, high temperature plasma and the foil trap 3. As a result of the increased pressure, the gas density of the gas curtain increases, which leads to an increase in the collision between gas atoms and debris. Debris loses its kinetic energy by repeated collision. In consequence, the energy of the debris decreases at the time of colliding at the EUV radiation collector optics 2, resulting in a reduction in the damage to the EUV radiation collector optics 2.

Furthermore, a gas supply unit 14 may be connected to the chamber 1 on the side of the EUV radiation collecting space 1b so as to introduce buffer gas that does not influence the emission of EUV radiation. Buffer gas supplied from the gas supply unit 14 passes through the foil trap 3 from the side of the EUV radiation collector optics 2, goes through the gap between a foil trap holding barrier 3a and a barrier 1c and then is withdrawn by the evacuation device 4. Such a flow of gas prevents debris that was not captured by the foil trap 3 from flowing into the side of EUV radiation collector optics 2, resulting in a reduction in the damage to the EUV radiation collector optics 2 caused by debris.

In addition to buffer gas, a halogen gas, such as chlorine ($Cl_2$), or hydrogen radicals, may be supplied to the EUV radiation collecting space from the gas supply unit 14. Such a gas functions as a cleaning gas for reacting with and then removing debris, which was not removed by the debris trap and accumulated on the EUV radiation collector optics 2. Thus, it is possible to prevent a decline in the reflectivity of the EUV radiation collector optics 2 caused by the accumulation of debris (i.e., a functional decline).

(7) Barrier

The pressure in the discharge space 1a needs to be set in a manner so that discharge can occur in a way suitable for heating and exciting the high temperature plasma raw material vaporized by the laser beam, whereby the discharge space can be kept under reduced pressure below a certain level.

The EUV radiation collecting space 1b needs to maintain a specified level of pressure at the debris trap because the kinetic energy of debris must be reduced by the debris trap.

In Figs. 4 & 5, a specific gas is flown from the gas curtain and a specified level of pressure maintained at the foil trap 3 in order to reduce the kinetic energy of debris. It is therefore necessary to maintain the EUV radiation collecting space 1b under reduced pressure of approximately several 100 Pa.

The EUV light source device according to the present invention is provided with the barrier 1c dividing the chamber 1 into the discharge space 1a and the EUV radiation collecting space 1b. The barrier 1c has an opening connecting both spaces. Since the opening functions as a pressure resistance, it is possible to maintain several Pa for the discharge space 1a and appropriate pressure for the EUV radiation collecting space 1b by properly taking into consideration the flow rate of gas from the gas curtain 13b, the size of the opening, the evacuation capacity of each evacuation device at a time when the discharge space is evacuated by the evacuation device 4 and the EUV radiation collecting space evacuated by the evacuation device 5.

(8) Material monitor

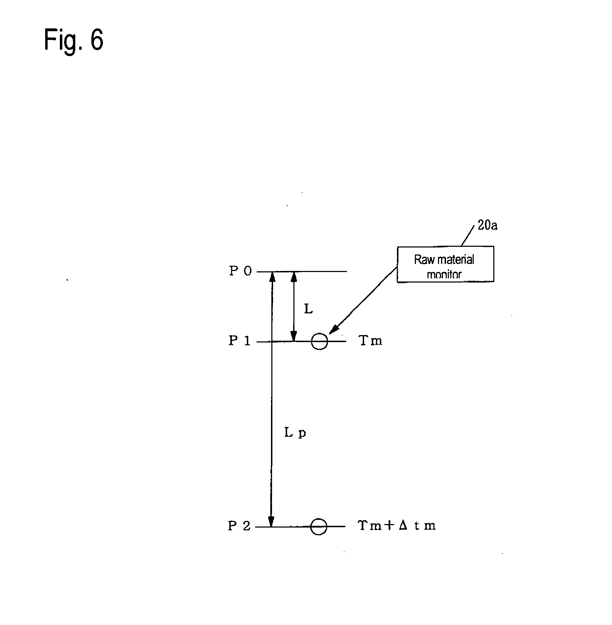

A material monitor 20a monitors the position of material 21 supplied drop-wise as droplets from the aforementioned raw material supply unit 20. As shown in Fig. 6, material monitor 20a monitors a point of time at which material 21 supplied as droplets from the raw material supply unit 20 reaches a position P1 in the vicinity of the raw material monitor 20a. This monitoring result allows finding of a period between a point of time at which material 21 reaches the position P1 and a point of time at which it reaches a position P2 where the laser beam 23 irradiates it as described below. The drops are monitored using a well-known laser measuring method, for example. Material detection signals are transmitted to a control part 26 from the raw material supply monitor 20a. Since material 21 is supplied as droplets, as described above, the raw material detection signals are interrupted pulse signals.

(9) Operation of the extreme ultraviolet (EUV) light source device

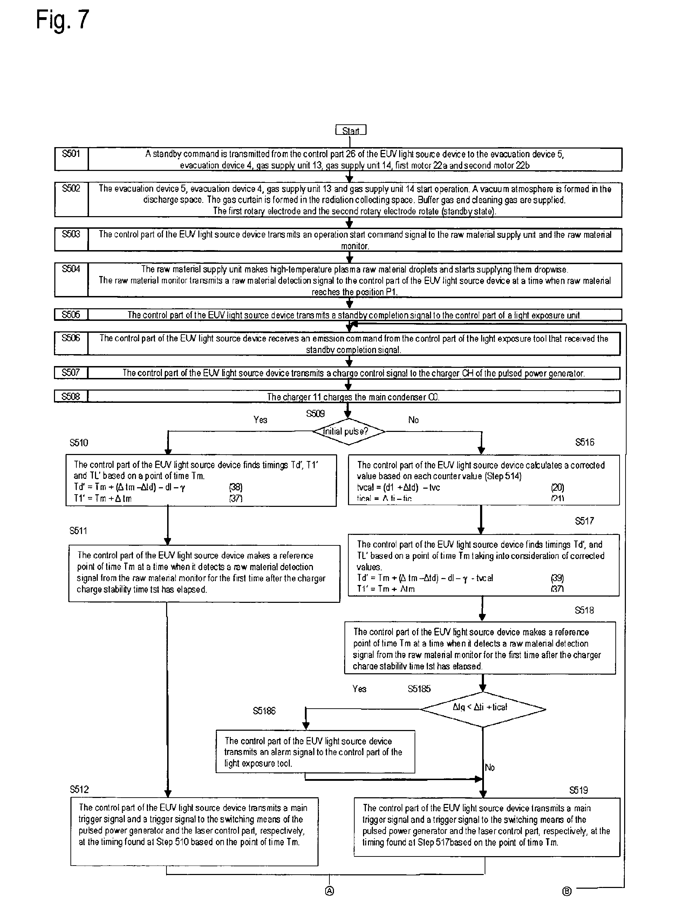

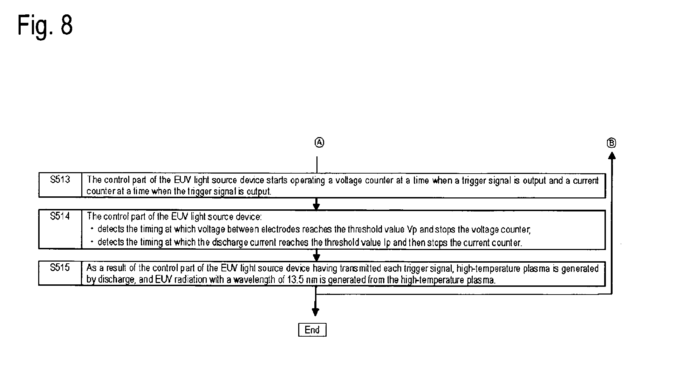

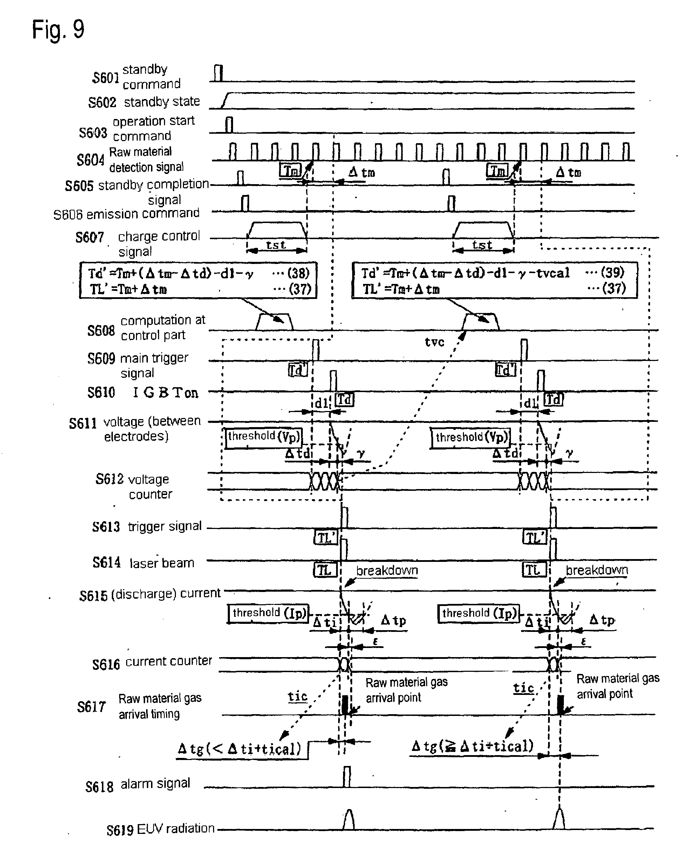

A description of the operation of the EUV light source device according to the present embodiment is given below, as an example, if it is used as a radiation source. Figs. 7 & 8 are first and second parts of a flowchart showing the operation of the present embodiment. Fig. 9 is a time chart. A description of the operation of the present embodiment is given below by referring to Figs. 7-9.

The control part 26 of the EUV light source device stores time data $\Delta td$, $\Delta ti$ and $\Delta tg$ as shown in Fig. 1.

That is, $\Delta td$ is a period between a point of time (Td) at which a trigger signal is input to a switching means of a pulsed power generator (i.e., the pulsed power generator 8) and a point of time at which the voltage between the electrodes reaches a threshold value Vp after the switching means was turned on. $\Delta ti$ is the time required for current flowing between the electrodes 11, 12 to reach the threshold Ip after discharge is started. $\Delta tg$ is a period between a point of time at which the laser beam 23 irradiates the raw material 21 and a point of time at which at least part of the vaporized raw material reaches a discharge area.

In general, the higher the voltage V applied to the discharge electrodes, the faster the startup of the voltage waveform between discharge electrodes. Accordingly, the aforementioned $\Delta td$ depends on the voltage V applied to discharge electrodes. The control part 26 of the EUV light source device stores data on the relationship between voltage V and time $\Delta td$ found by experiments in advance as a table.

The control part 26 of the EUV light source device also stores a period $\Delta tm$ between a point of time at which raw material 21 reaches a specified position (e.g., P1 in Fig. 6) and a point of time at which it reaches a position where the laser beam 23 irradiates the raw material 21 (e.g., P2 in Fig. 6).

Moreover, the control part 26 stores correction time $\gamma$ and $\varepsilon$ and a delay time d1 between a point of time at which a main trigger signal is output to the switching means of the pulsed power generator 8 and a point of time at which the main trigger signal is input to the switching means of the pulsed power generator 8 to turn the switching means on. The correction time $\gamma$ and $\varepsilon$ will be described below.

First, a standby command is transmitted from the control part 26 of the EUV light source device to the evacuation device 5, evacuation device 4, gas supply unit 13, gas supply unit 14, first motor 22a and second motor 22b (Step S501 in Fig. 7 and S601 in Fig. 9).

Upon receiving the standby command, the evacuation device 5, evacuation device 4, gas supply unit 13 and gas supply unit 14 start operation. That is, the evacuation device 4 starts its operation to generate a vacuum atmosphere in the discharge space. The evacuation device 5 starts its operation and the gas supply unit 13 starts its operation to form the gas curtain 13b. The gas supply unit 14 starts its operation to supply buffer gas and cleaning gas to the EUV radiation collecting space 1b. As a result, the EUV radiation collecting space 1b reaches a specified pressure. Moreover, the first motor 22a and the second motor 22b start their operation to rotate the first rotary electrode 11 and the second rotary electrode 12, respectively. As used herein, the aforementioned operation state is referred to as the standby state collectively (Step S502 in Fig. 7 and S602 in Fig. 9).

After the standby sate, the control part 26 of the EUV light source device transmits an operation start command signal to the raw material supply unit 20 and the raw material monitor 20a (Step S503 in Fig. 7 and S603 in Fig. 9). Upon receiving the operation start command signal, the raw material supply unit 20 makes liquid or solid high temperature plasma raw material 21 (e.g., Sn in the liquid state) droplets and starts supplying them drop-wise. On the other hand, the raw material monitor 20a starts its monitoring operation and transmits a material detection signal to the control part 26 of the EUV light source device at a time when material 21 reaches the position P1 in Fig. 6 as described below (Step S504 in Fig. 7 and S604 in Fig. 9).

At this point, raw material 21 supplied drop-wise has not been irradiated by the laser beam 23 yet and, therefore, is recovered by a material recovery means 25.

The control part 26 of the EUV light source device transmits a standby completion signal to the control part 27 of a light exposure tool (Step S505 in Fig. 7 and S605 in Fig. 9).

The control part 26 of the EUV light source device receives an emission command from the control part 27 of the light exposure tool that received the standby completion signal. In the case that the light exposure tool controls the intensity of EUV radiation, the emission command includes data on the intensity of EUV radiation (Step S506 in Fig. 7 and S606 in Fig. 9).

The control part 26 of the EUV light source device transmits a charge control signal to the charger CH of the pulsed power generator 8. The charge control signal is comprised of discharge start timing data, for example. As described above, if an emission command from the control part 27 of the light exposure tool contains data on the intensity of EUV radiation, the aforementioned charge control signal also includes a charging voltage data signal for the main capacitor C0.

As an example, the relationship between the intensity of EUV radiation and a charging voltage for the main capacitor C0 is found by experiments in advance to make a table for storing data on the relationship. The control part 26 of the EUV light source device stores this table and retrieves charging voltage data of the main capacitor C0 from the table based on the data on the intensity of EUV radiation contained in an emission command transmitted from the control part 27 of the light exposure tool. Based on the charging voltage data thus retrieved, the control part 26 of the EUV light source device transmits a charge control signal, which contains a charging voltage data signal to be transmitted to the main capacitor C0, and to the charger CH of the power supply generator 8 (Step S507 in Fig. 7 and S607 in Fig. 9).

As described above, the charger CH charges the main capacitor C0 (Step S508 in Fig. 7).

The control part 26 of the EUV light source device determines if it is the first generation of EUV radiation after operation was started (the initial pulse as used here) or not (Step S509 in Fig. 7). If it is the initial pulse, the procedure is moved to Step S510 from Step S509. If it is not, the initial pulse, the procedure is moved to Step 516.

At Step 510, the control part 26 of the EUV light source device calculates the timing of outputting a main trigger signal to the switching means of the pulsed power generator 8 and the timing of transmitting a trigger signal to a laser control part 23b that controls the operation of the laser source 23a.

In the case of the initial pulse, the aforementioned timings are determined based on the prestored time data $\Delta$td, $\Delta$ti, $\Delta$tm, di and $\gamma$ because count values of voltage counter and current counter (as described below) cannot be used, and therefore, feedback correction (as described below) cannot be carried out.

As shown in Fig. 1, it is desirable to set the time TL at which a laser beam is emitted based on a point of time Td at which a main trigger signal is input into the switching means of the pulsed power generator 8 to turn on the switching means.

In the present embodiment, a delay time d1 was found between a point of time Td' at which a main trigger signal was output to the switching means of the pulsed power generator 8 and a point of time Td at which the main trigger signal was input into the switching means of the pulsed power generator 8 to turn on the switching means in advance and then found the point of time Td when the switching means is turned on by correcting the point of time Td' at which a main trigger signal was output to the switching means of the pulsed power generator 8 using the aforementioned delay time d1.

Here, a delay time dL was disregarded between a point of time TL' at which a trigger signal is transmitted and a point of time at which the laser beam 23 is emitted because it is as small the order of a ns.

If the laser source 23a is a Q switch-type Nd:YAG laser device, a point of time TL at which a laser beam is emitted can be set based on a point of time Td at which a main trigger signal is input into the switching means of the pulsed power generator 8 by setting the timing TL' for transmitting a trigger signal to the laser control part 23b, which controls the operation of the laser source 23a, based on a point of time Td' at which the main trigger signal is output to the switching means of the pulsed power generator 8.

Based on a point of time (Td') at which a main trigger signal is transmitted, the timing TL' for transmitting a trigger signal to the laser control part 23b can be found as follows:

As shown in Fig. 1, the timing TL at which a laser beam is irradiated is expressed by the following equation based on a point of time Td at which the switching means of the pulsed power generator 8 is turned on.

$$TL \geq Td + \Delta td \qquad (26)$$

Accordingly, based on a point of time Td' at which a main trigger is transmitted, the timing TL' for transmitting a trigger signal to the laser control part to control the operation of the laser source 23a is expressed as follows:

$$TL' + dL \geq (Td' + d1) + \Delta td \qquad (28)$$

Here, since a delay time dL is ignorably small, the timing TL' for transmitting a trigger signal is expressed as follows:

$$TL' \geq Td' + d1 + \Delta td \qquad (29)$$

A point of time at which the laser beam 23 is emitted can be delayed slightly more than $\Delta td$ in order to be certain that the laser beam 23 is emitted after a voltage between the electrodes exceeds the threshold value Vp. Given that the delay time is $\gamma$, the equation (29) can be modified to the following expression.

$$TL' \geq Td' + d1 + \Delta td + \gamma \qquad (30)$$

In the present embodiment,

$$TL' = Td' + d1 + \Delta td + \gamma \qquad (31)$$

Needless to say, the setting of TL' is not limited to the equation (31). Any equation can be used as far as it satisfies the expression (30). For example, the following equation is usable:

$$TL' = Td' + d1 + \Delta td$$

As described above, a period $\Delta tg$ between a point of time at which the laser beam 23 irradiates the raw material 21 and a point of time at which at least part of the vaporized raw material reaches the discharge area and a point of time TL at which the laser beam 23 irradiates the high temperature plasma raw material 21 need to satisfy the following relationship.

$$TL + \Delta ti \leq TL + \Delta tg \leq TL + \Delta ti + \Delta tp \qquad (27)$$

In the equation (27), it is assumed that a point of time at which a laser beam irradiates the high temperature plasma raw material and a point of time at which the laser beam irradiates the discharge area are substantially the same.
If the equation (27) is modified to show the relationship between the timing TL' for transmitting a trigger signal to the laser control part and $\Delta tg$, the following expression (32) is obtained.

$$TL' + \Delta ti \leq TL' + \Delta tg \leq TL' + \Delta ti + \Delta tp \qquad (32)$$

That is, the relationship between Δtg and Δti is expressed as follows:

$$\Delta ti \leq \Delta tg \leq \Delta ti + \Delta tp \qquad (33)$$

As described above, Δtg depends on the positions of the discharge area and raw material, the direction of irradiation of the raw material 21 with the laser beam 23 and the radiation energy of the laser beam 23. These parameters are properly set so that the expression (33) can be satisfied.

In the present embodiment, Δtg is set in such a way that at least part of the vaporized raw material reaches the discharge area surely after the discharge current exceeds the threshold value Ip. In other words, Δtg is set to be slightly longer than Δti. Given that the correction time is ε, the relationship between Δtg and Δti is expressed as follows:

$$\Delta tg = \Delta ti + \varepsilon \quad (\varepsilon \leq \Delta tp) \qquad (34)$$

That is, the parameters (i.e., the positions of the discharge area and raw material, the direction of irradiating the raw material with the laser beam and the radiation energy of the laser beam) are properly set so that the equation (34) can be satisfied.

As described above, the timing TL' for transmitting a trigger signal based on a point of time Td' for transmitting a main trigger signal is expressed by the equation (31).

In the EUV light source device according to the present embodiment, raw material is supplied drop-wise as droplets. Accordingly, a point of time at which the raw material supplied drop-wise reaches the radiating position P2 of the laser beam, as shown in Fig. 6, needs to be synchronized with the aforementioned point of time Td' for transmitting a main trigger signal and the timing TL' for transmitting a trigger signal.

Given that a point of time at which raw material reaches the position P1 is Tm and that, Δtm after Tm, the raw material reaches the radiating position P2 in Fig. 6, a point of time at which the raw material reaches the radiating position P2 is expressed by Tm + Δtm.

That is, based on the point of time Tm, the following equation needs to be satisfied.

$$TL = Tm + \Delta tm \qquad (35)$$

The expression (32) can be modified to the equation of the timing TL' for transmitting a trigger signal as follows.

$$(TL' + dL) = Tm + \Delta tm \qquad (36)$$

Since the delay time dL is ignorably small, the equation (36) can be changed to the following equation.

$$TL' = Tm + \Delta tm \qquad (37)$$

Accordingly, based on the point of time Tm, the point of time Td' for transmitting a main trigger signal and the timing TL' for transmitting a trigger signal to the laser control part 23b are found as follows:

$$Td' = Tm + (\Delta tm - \Delta td) - dl - \gamma \qquad (38)$$

$$TL' = Tm + \Delta tm \qquad (37)$$

Here, by referring to Fig. 6, $\Delta$tm can be found as follows:

As shown in Fig. 6, the position of the raw material discharge part in the raw material supply unit 20 is P0, the position where the raw material monitor 20 monitors material 21 is P1, the radiating position of a laser beam P2, the distance between P0 and P1 is L and the distance between P0 and P2 is Lp.

Also, based on the time when material is located at P0, a point of time at which material reaches P1 is Tm, as described above, and that a point of time at which the raw material reaches the radiating position P2 is Tm + $\Delta$tm.

Given that the fall velocity of the raw material is 0 at the position P0 and the acceleration of gravity G, the following equations are expressed.

$$L = (1/2)\,GTm^2 \qquad (17)$$

$$Lp = (1/2)\,G\,(Tm + \Delta tm)^{\,2} \qquad (18)$$

Based on the equations (17) and (18), $\Delta$tm can be found as follows (equation (19)):

$$\Delta tm = (2Lp\,/\,G)^{\,1/2} - (2L\,/\,G)^{1/2} \qquad (19)$$

That is, in Step 510, the control part 26 of the EUV light source device finds the timing Td' for transmitting a main trigger signal and the timing TL' for transmitting a trigger signal to the laser control part based on the point of time Tm using pre-stored time data $\Delta$td, $\Delta$ti, $\Delta$tm, d1 and $\gamma$ and equations (38), (37) and (19) (S608 in Fig. 9).

Here, the time data $\Delta$td is retrieved from a table that stores the relationship between voltage V and time $\Delta$td.

As data on voltage V applied to the discharge electrodes, charging voltage data of the main capacitor C0 can be used, for example, that is retrieved from a table storing data on correlation between the intensity of EUV radiation and charging voltage to the main capacitor C0 at the time of transmitting a charge control signal to the charger CH of the pulsed power generator 8 in Step 507.

The control part 26 of the EUV light source device makes a reference point of time Tm at a time when it detects a material detection signal from the raw material monitor for the first time after the charger charge stability time tst has elapsed (Step S511 in Fig. 7 and S604 in Fig. 9). The setting of the reference point of time Tm is not limited to a point of time at which it detects a material detection signal from the raw material monitor for the first time after the charger charge stability time tst has elapsed. A point of time at which a specified number of material detection signals is detected after the time tst has elapsed may be set as the reference point of time Tm.

The control part 26 of the EUV light source device transmits a main trigger signal and a trigger signal to the switching means of the pulsed power generator 8 and the laser control part 23b at the timing Td' for transmitting a main trigger signal and the timing TL' for transmitting a trigger signal based on the point of time Tm, which was found by the equations (38), (37) and (19), respectively (Step S512 in Fig. 7 and S609 and S613 in Fig. 9).

The control part 26 of the EUV light source device starts operating a voltage counter at a time when a main trigger signal is output for measuring the voltage between the electrodes until it reaches the threshold Vp.

It also starts operating a current counter at a time when a trigger signal is output for measuring the discharge current until it reaches the threshold value Ip (Step S513 in Fig. 8 and S612 and S616 in Fig. 9). The voltage counter and current counter are cleared to a 0 state at a time when an emission command signal is input from the control part 27 of the light exposure tool.

The voltage counter is used for feedback control in order to keep the time required for the voltage between the electrodes to reach the threshold value Vp constant after the output of a main trigger signal. The current counter is used for checking if the relationship between $\Delta$tg and $\Delta$ti satisfies the equation (34) or not after the output of a trigger signal. In other words, the timing Td' for transmitting a main trigger signal and the timing TL' for transmitting a trigger signal to the laser control part based on the point of time Tm are determined by the equations (38), (37) and (19) at the first irradiation (i.e., the initial pulse) as described above and are determined by the values obtained by correcting the aforementioned equations (38), (37) and (19) based on the count values of the aforementioned voltage counter at the second trial and thereafter as described below.

The control part 26 of the EUV light source device detects the timing at which the voltage between the electrodes reaches the threshold Vp using a voltage monitor (not shown in Figs. 4 & 5) and then stops the voltage counter. It also detects the timing at which the discharge current reaches the threshold value Ip using a current monitor (not shown in Figs. 4 & 5) and then stops the current counter (Step S514 in Fig. 8 and S612 and S616 in Fig. 9).

In Step S512, at a time when a delay time d1 has elapsed after a main trigger signal is transmitted at the timing Td' based on the equation (38) and then the main trigger signal is input to the switching means of the pulsed power generator 8, the switching means (e.g., IGBT) is turned on (S609 and S610 in Fig. 9).

After the switching means is turned on, the voltage between the first rotary electrode 11 and the second rotary electrode 12 starts rising and, $\Delta$td later, reaches the threshold value Vp. As described above, the threshold value Vp is a voltage value at a time when a value of the discharge current, which flows at the time of the generation of discharge, exceeds the threshold value Ip (S610 and S611 in Fig. 9).

In Step S512, as described above, a trigger signal is transmitted to the laser control part 23b at the timing TL' based on the equation (37). As a result, a laser beam irradiates the discharge area at a point of time TL which is at or after a point of time (Td + $\Delta$td) when the voltage between the electrodes reaches the threshold value Vp (S613 and S614 in Fig. 9).

After a laser beam irradiates the discharge area, discharge occurs in the discharge area. A period $\Delta$ti after the start of the discharge, a discharge current value reaches the aforementioned threshold value Ip (S614 and S615 in Fig. 9). The threshold value Ip is the lower limit of the discharge current value required for generating EUV radiation of a specific intensity. Here, a period during which a discharge current value exceeds the threshold value Ip is $\Delta$tp.

Here, the timing at which the laser beam 23 passes through the discharge area can be considered to be substantially the same as the timing at which it irradiates the high temperature plasma raw material 21. The energy of the laser beam 23 at the position where it irradiates the high temperature plasma raw material 21, the radiating direction of the laser beam 23 and the positional relationship between the discharge area and high temperature plasma raw material 21 are properly set in such a way as to satisfy the expressions (26) and (27).

Accordingly, at least part of the vaporized raw material having a specified spatial density distribution reaches the discharge area during a period in which the discharge current value exceeds the lower limit of the discharge current value required for generating EUV radiation of a specified intensity (S617 in Fig. 9).

As a result of the control part 26 of the EUV light source device having transmitted each of the trigger signals in Step S512, a discharge channel is fixed to a specified position. At a time when at least part of the vaporized raw material having a specified spatial density distribution has reached the discharge channel, the position of which has been fixed, electric discharge occurs in such a way that a discharge current value exceeds the lower limit of the discharge current value required for generating EUV radiation of a specific intensity.

The electric discharge occurs between the edges of the peripheral portions of the first rotary electrode 11 and the second rotary electrode 12 to form plasma. At a time when the plasma is heated and excited by high pulse current flowing inside the plasma, EUV radiation with a wavelength of 13.5 nm is generated from the high temperature plasma (Step S515 in Fig. 8).

The aforementioned specified spatial density distribution is set in such a way that EUV radiation can be generated as efficiently as possible. More specifically, the position of supplying high temperature plasma raw material 21 to the discharge area, the radiating direction of the laser beam 23 to the high temperature plasma raw material, the radiating energy of the laser beam 23 and the like are properly set in such a way that EUV radiation can be generated as efficiently as possible.

A discharge channel is fixed to a specified position by irradiation with the laser beam 23, thereby further stabilizing the position generated by plasma.

In other words, the transmission of each trigger signal by the control part 26 of the EUV light source device allows achieving the efficient generation of EUV radiation and stabilizing the position of generating EUV radiation.

The EUV radiation emitted from the plasma passes through an opening provided in the barrier 1c and the foil trap 3, is converged on the grazing incidence type EUV radiation collector optics 2 provided in the EUV radiation collecting space 1b and then is guided to the illumination optical system of a lithography tool (not shown here) via the EUV radiation extracting part 7 provided for the chamber 1.

At the end of the initial EUV radiation, the procedure returns to Step S506 and stands by for an emission command from the light exposure tool.

After receiving an emission command, the procedure moves on to Steps S507 and S508 and to Step S509. Since the next irradiation is not the initial pulse, the procedure moves from Step S509 to Step S516. In Step 516, the control part 26 of the EUV light source device carries out the feedback calculation of the timing TL' for transmitting a trigger signal to the laser control part using the following equations based on a value in the voltage counter for a period between a point of time at which a main trigger signal is output and a point of time the voltage between the electrodes reaches the threshold value Vp and a value in the current counter for a period between a point of time at which a trigger signal is output and a point of time at which discharge current reaches the threshold value Ip, which were measured in Step S514.

$$tvcal = (d1 + \Delta td) - tvc \qquad (20)$$

$$tical = \Delta ti - tic \qquad (21)$$

Here, tvcal is a correction value of a period between a point of time at which a main trigger signal is output and a point of time the voltage between the electrodes reaches the threshold value Vp, and tvc is time measured by the voltage counter. Also, tical is a correction value of a period between a point of time at which a trigger signal is output and a point of time at which discharge current reaches the threshold value Ip, and tic is time measured by the current counter (Step S516 in Fig. 7 and S608 in Fig. 9).

As shown in the equation (20), tvcal is a correction value of the sum total of a delay time d 1 between a point of time Td' at which a main trigger signal is output and a point of time at which the main trigger signal is input to the switching means of the pulsed power generator 8 to turn the switching means on and a period between a point of time at which the switching means is turned on and a point of time at which the voltage between the electrodes reaches the threshold value Vp.

As described above, a semiconductor switching element such as IGBT, which can flow high current, is frequently used as a solid switch SW, which is the switching means of the pulsed power generator 8.

In the semiconductor switching element, such as IGBT, a period between a point of time at which a gate signal, which corresponds to a main trigger signal in the present embodiment, is input and a point of time at which it is turned on varies to some degree. That is, the equation (20) can correct such a variation of the switching element.

The control part 26 of the EUV light source device determines the timing Td' for transmitting a main trigger signal based on a point of time Tm and the timing TL' for transmitting a trigger signal to the laser control part 23b by the following equations taking into consideration of correction values found in Step S516 (Step S517 and S608 in Fig. 9).

$$Td' = Tm + (\Delta tm - \Delta td) - dl - \gamma - tvcal \qquad (39)$$

$$TL' = Tm + \Delta tm \qquad (37)$$

$$\Delta tm = (2Lp / G)^{1/2} - (2L / G)^{1/2} \qquad (19)$$

The control part 26 of the EUV light source device makes a reference point of time Tm at a time when it detects a raw material detection signal from the raw material monitor for the first time after the charger charge stability time tst has elapsed (Step S518 in Fig. 7 and S604 in Fig. 9). The setting of the reference point of time Tm is not limited to a point of time at which it detects a material detection signal from the raw material monitor for the first time after the charger charge stability time tst has elapsed. A point of time at which a specified number of material detection signals is detected after the time tst has elapsed may be set as the reference point of time Tm.

Next, the procedure moves on to Step S5185, where the control part 26 of the EUV light source device examines the relationship between $\Delta ti$ corrected by a correction value tical for a period between a point of time at which a trigger signal is output and a point of time at which discharge current reaches the threshold value Ip and $\Delta tg$.

That is, it examines the size of $\Delta ti$ + tical and that of $\Delta tg$. If it is found as a result of the examination that $\Delta tg$ is smaller than $\Delta ti$ + tical ($\Delta tg < \Delta ti$ + tical), the procedure moves on to Step S5186. On the other hand, if it is found that $\Delta tg$ is equal to or larger than $\Delta ti$ + tical ($\Delta tg \geq \Delta ti$ + tical), the procedure moves on to Step 519.

In the case of $\Delta tg < \Delta ti$ + tical, at least part of the vaporized raw material having a specified spatial density distribution reaches the discharge area before the discharge current reaches the threshold value Ip. For this reason, undesirable emission occurs during a period between a point of time at which at least part of the vaporized raw material having a specified spatial density distribution reaches the discharge area and a point of time at which the discharge current reaches the threshold value Ip. As a result, radiation of wavelengths other than 13.5 nm is mixed with EUV radiation emitted from the discharge area. In other words, the spectral purity of EUV radiation emitted from the EUV light source device deteriorates. In Step S5186, the control part 26 of the EUV light source device transmits an alarm signal showing the deterioration of spectral purity to the control part 27 of the light exposure tool (S618 in Fig. 9).

If the operation of the EUV light source device should be continued even after the transmission of an alarm signal, the procedure moves on to Step S519.

If the operation of the EUV light source device should be stopped after the transmission of an alarm signal, the operation of the EUV light source device is stopped in the aforementioned Step S5186. Then, parameters such as the positions of the discharge area and raw material, the radiating direction of the laser beam and the radiating energy of the laser beam should be reset in such a way as to satisfy the equation (34).

In the present embodiment, the operation of the EUV light source device is continued even after an alarm signal is transmitted. In the case of $\Delta tg \geq \Delta ti + tical$ in Step S5185, at least part of the vaporized raw material reaches the discharge area after a point of time at which the discharge current reaches the threshold Ip. Accordingly, the procedure moves on to Step S519 in Fig. 7 because there is no deterioration in spectral purity.

The purpose of the aforementioned examination in Step S5185 is to exclude the influence of a jitter of a period $\Delta ti$ between a point of time at which discharge is started and a point of time at which the current value reaches the threshold value Ip. If it is already known that a correction time $\varepsilon$ ($\varepsilon \leq \Delta tp$) in the equation (34) is fully larger than the aforementioned jitter, it is possible to omit the examination in Step S5185.

In Step S519 in Fig. 7, based on the point of time Tm set in Step S518, the control part 26 of the EUV light source device transmits a main trigger signal and a trigger signal to the switching means of the pulsed power generator 8 and the laser control part at the timing Td' for transmitting a main trigger signal and the timing TL' for transmitting a trigger signal based on the reference point of time Tm, which was found by the equations (39), (37) and (19), respectively (S609 and S613 in Fig. 9).

Next, the procedure moves on to Step S513 in Fig. 8. The control part 26 of the EUV light source device starts operating a voltage counter at a time when a main trigger signal is output for measuring the voltage between the electrodes until it reaches the threshold Vp. It also starts operating a current counter at a time when a trigger signal is output for measuring the discharge current until it reaches the threshold Ip (S612 and S616 in Fig. 9). As described above, the voltage counter and current counter are cleared to the 0 state at a time when an emission command signal is input from the control part of the light exposure tool.

The control part 26 of the EUV light source device detects the timing at which the voltage between the electrodes reaches the threshold value Vp using a voltage monitor (not shown in Figs. 4 & 5) and then stops the voltage counter. It also detects the timing at which the discharge current value reaches the threshold value Ip using a current monitor (not shown in Figs. 4 & 5) and then stops the current counter (Step S514 in Fig 8 and S612 and S616 in Fig. 9).

In Step S519, at a time when a delay time d1 has elapsed after a main trigger signal is transmitted at the timing Td' based on the equation (39) and then the main trigger signal is input to the switching means of the pulsed power generator 8, the switching means (e.g., IGBT) is turned on (S609 and S610 in Fig. 9). After the switching means is turned on, the voltage between the first rotary electrode 11 and the second rotary electrode 12 starts rising and, $\Delta td$ later, reaches the threshold value Vp (S610 and S611 in Fig. 9).

In Step S519, as described above, a trigger signal is transmitted to the laser control part at the timing TL' based on the equation (37). As a result, the laser beam 23 irradiates the discharge area at a point of time TL which is at or after a point of time (Td + $\Delta td$) when the voltage between the electrodes reaches the threshold value Vp (S613 and S614 in Fig. 9).

After the laser beam 23 irradiates the discharge area, discharge occurs in the discharge area. $\Delta ti$ after the start of the discharge, a discharge current value reaches the aforementioned threshold value Ip (S614 and S615 in Fig. 9). The threshold value Ip is the lower limit of the discharge current value required for generating EUV radiation of a specific intensity. Here, a period during which a discharge current value exceeds the threshold value Ip is $\Delta tp$.

Here, the timing at which the laser beam 23 passes through the discharge area can be considered to be substantially the same as the timing at which it irradiates the high temperature plasma raw material 21. The energy of the laser beam 23 at the position where it irradiates the high temperature plasma raw material 21, the radiating direction of the laser beam 23 and the positional relationship between the discharge area and high temperature plasma raw material 21 are properly set in such a way as to satisfy the expressions (26) and (27).

Accordingly, at least part of the vaporized raw material having a specified spatial density distribution reaches the discharge in a time period during which the discharge current value exceeds the lower limit of the discharge current value required for generating EUV radiation of a specified intensity (S617 in Fig. 9).

As a result of the control part 26 of the EUV light source device having transmitted each trigger signal in Step S512, the discharge channel is fixed to a specified position. At a time when at least part of the vaporized raw material having a specified spatial density distribution has reached the discharge channel, the position of which has been fixed, electric discharge occurs in such a way that the discharge current value exceeds the lower limit of the discharge current value required for generating EUV radiation of a specific intensity.

The electric discharge occurs between the edges of the peripheral portions of the first rotary electrode 11 and the second rotary electrode 12 to form plasma. At a time when the plasma is heated and excited by high pulse current flowing inside the plasma, EUV radiation with a wavelength of 13. 5 nm is generated from the high temperature plasma (Step S515 in Fig. 8).

The aforementioned specified spatial density distribution is set in such a way that EUV radiation can be generated as efficiently as possible.

A discharge channel is fixed to a specified position by irradiation with a laser beam, thereby further stabilizing the position generated by plasma.

In other words, the transmission of each trigger signal by the control part of the EUV light source device allows achieving the efficient generation of EUV radiation and stabilizing the position of generating EUV radiation.

The EUV radiation emitted from plasma passes through an opening provided in a barrier and a foil trap, is converged on grazing incidence type EUV radiation collector optics provided in the EUV radiation collecting space and then is guided to the illumination optical system of a lithography tool (not shown here) via an EUV radiation extracting part provided for the chamber.

As long as the exposure process is continued, the steps between Step S506 and Step S515 are repeated. If the radiation exposure is brought to an end, the procedure also comes to an end after Step S515.

The aforementioned operation allows the timing at which the laser beam 23 passes through a discharge area to be properly set, the timing at which it irradiates the high temperature plasma raw material 21, the intensity of the laser beam 23 condensed in the discharge area, the energy of the laser beam 23 at the position where it irradiates the high temperature plasma raw material 21, the radiating direction of the laser beam 23 and the positional relationship between the discharge area and the high temperature plasma raw material 21.

While the high temperature plasma raw material 21 keeps a specified spatial density distribution in the discharge area after at least part of the vaporized high temperature plasma raw material 21 having a specified spatial density distribution has reached the discharge area, discharge current initiated by irradiation with the laser beam 23 reaches a specified value, and then EUV radiation of a specified intensity is generated.

That is, in the present embodiment, electric discharge is initiated by irradiating one laser beam, the position of a discharge channel is fixed in the discharge area and then the discharge current reaches a specified value while the raw material maintains a specified spatial density distribution in the discharge channel, the position of which has been fixed. Accordingly, EUV radiation can be generated efficiently.

Moreover, since the discharge channel is fixed on the radiation focusing line of the laser beam, the positional stability of the originating point of EUV radiation can be enhanced.

More particularly, the feedback control is carried out in the present embodiment so that a period between the beginning of an output of the main trigger signal and a point of time at which the voltage between the electrodes reaches the threshold Vp can be kept constant. Accordingly, it is possible to achieve efficient EUV radiation without fail if there occurs some variation in the operation of a semiconductor switching element such as IGBT used as a solid switch SW (i.e., a switching means of the pulsed power generator 8).

As shown in Fig. 5, a magnet 6 may be used in the vicinity of the discharge area where plasma is to be generated in order to place plasma in a magnetic field. The application of a uniform magnetic field substantially in parallel to the direction of electric discharge generated between the first and second rotary electrodes 11, 12, respectively, allows making the size of high temperature plasma, from which EUV is emitted, (i.e., the size of an EUV radiating species) small, and therefore, making the emission duration of the EUV radiation longer. In other words, the EUV light source device according to the present invention can be improved as a light source device by applying a magnetic field.

2. Alternative embodiments of the aforementioned embodiment

In the EUV light source device according to the present invention, high temperature plasma raw material used for emitting extreme ultraviolet radiation is in the liquid or solid state and is supplied to the neighborhood of a discharge area.

In the EUV light source device according to the aforementioned embodiment, the aforementioned material is supplied as droplets. Needless to say, the supply mechanism of high temperature plasma raw material is not limited to this method.

A description of alternative embodiments is given below in terms of the raw material supply unit of high temperature plasma raw material.

(1) First alternative embodiment

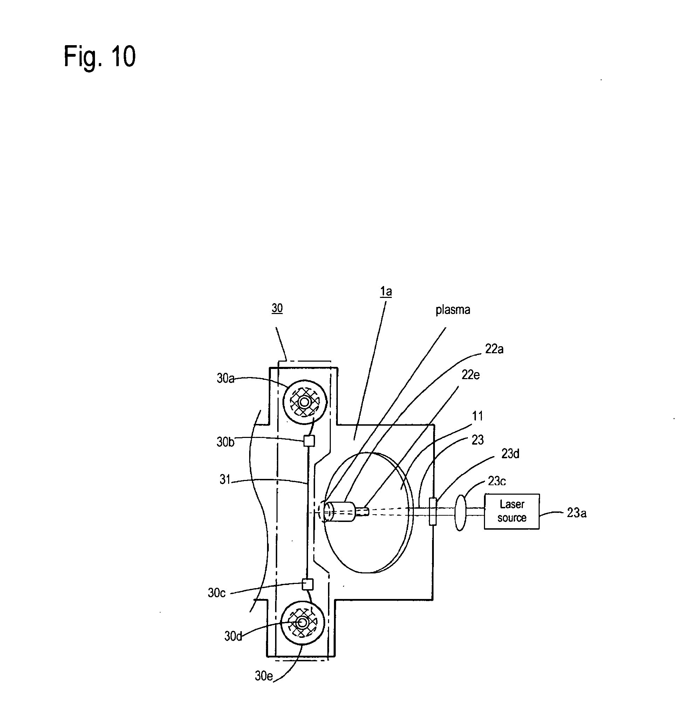

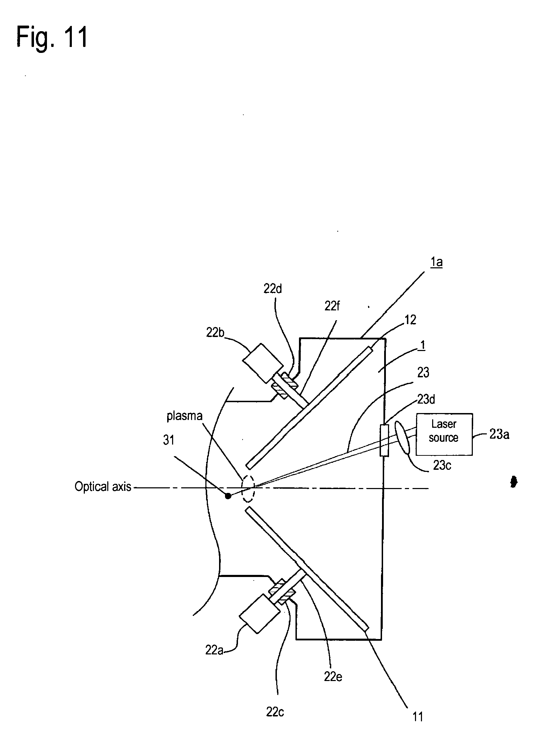

Figs. 10 & 11 are views explaining the first alternative of the present embodiment. More specifically, Fig. 10 is a front view of the EUV light source device according to the present invention. EUV radiation is extracted on the left side in the drawing. In Fig. 10, the raw material supply unit is replaced for one in the EUV light source device in Fig. 4. Fig 10 mainly shows the arrangement and configuration of the raw material supply unit and omits part of the EUV light source device so as to make the understanding easier. The omitted part is the same as in Fig. 4.

Fig. 11 is a top view of the EUV light source device according to the present invention. Like Fig. 10, part of the EUV light source device is omitted.

In the alternative embodiment as shown in Figs. 10 & 11, linear raw material 31 is used as the high temperature plasma raw material. Specifically, it is a metal wire containing an extreme ultraviolet radiating species such as Sn (tin).

The raw material supply unit 30, in the first alternative embodiment, allows supplying linear raw material 31 to a specified space. The raw material supply unit 30 comprises a reel 30a, a reel 30e, a positioning means 30b, a positioning means 30c, linear raw material 31 and a drive mechanism 30d. The drive mechanism 30d is driven and controlled by a control part (not shown in Figs. 10 & 11).

The linear raw material 31 is wound around reels 30a, 30e. The reel 30a is located on the upper side for sending the linear material 31. The reel 30e is located on the lower side for winding the linear raw material 31 sent from the reel 30a. The linear raw material 31 is sent from the reel 30a as the drive mechanism 30d rotationally drives the reel 30e.

The linear raw material 31 sent from the reel 30a is vaporized by irradiation with the laser beam 23 emitted from a laser source 23a. As described above, the spreading direction of high temperature plasma raw material depends on the position of the laser beam 23 incident on the raw material 31.

The linear material 31 is positioned using the positioning means 30b, 30c in such a way that the position of the laser beam 23 incident on the raw material 31 faces the discharge area. Here, the position of the linear raw material 31 is determined so that raw material vaporized by the laser beam 23 irradiating the linear raw material 31 can reach the discharge area.

The optical axis of the laser beam 23 emitted from the laser source 23a and the energy of the laser beam 23 are adjusted such that vaporized high temperature plasma raw material can spread in the direction of the discharge area after the linear raw material 31 is supplied and the laser beam 23 irradiates the linear raw material 31.

Here, the distance between the discharge area and the linear raw material 31 is set in such a way that vaporized high temperature plasma raw material spreading in the direction of the discharge area as a result of the irradiation of the laser beam can reach the discharge area while keeping a specified spatial density distribution.

As shown in Figs. 10 & 11, it is preferred that the linear raw material 31 is supplied to the space between the pair of electrodes 11, 12 and the EUV radiation collector optics 2.

As described above, the laser beam 23 irradiates the surface of the linear raw material 31 thus supplied on the side facing the discharge area. As a result, vaporized linear raw material spreads in the direction of the discharge area, but does not spread in the direction of the EUV radiation collector optics 2.

By setting the position of the linear raw material 31 to be supplied relative to the discharge area and the radiating position of the laser beam 23 as described above, it is possible to prevent debris from advancing toward the EUV radiation collector optics 2.

(2) Second alternative embodiment

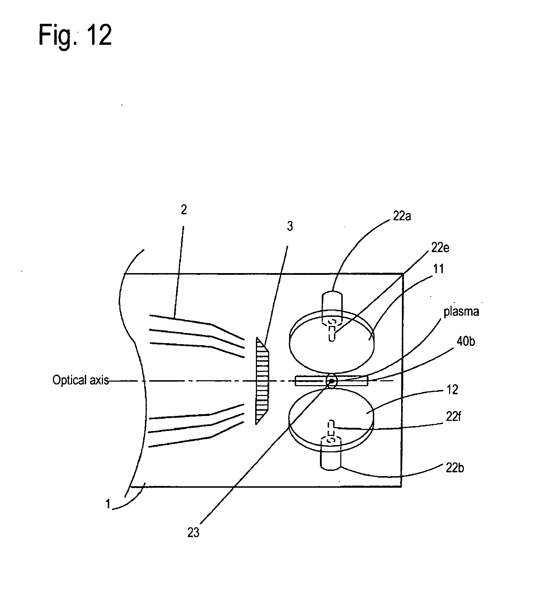

Figs. 12-14 are views explaining the second alternative of the present embodiment. More specifically, Fig. 12 is a front view of the EUV light source device according to the present invention. EUV radiation is extracted on the left side in the drawing. In Fig. 12, the raw material supply unit 20 of the EUV light source device shown in Fig. 4 is replaced.

Fig 12 mainly shows the arrangement and configuration of the raw material supply unit and omits part of the EUV light source device so as to make the understanding easier. The omitted part is the same as one in Fig. 4.

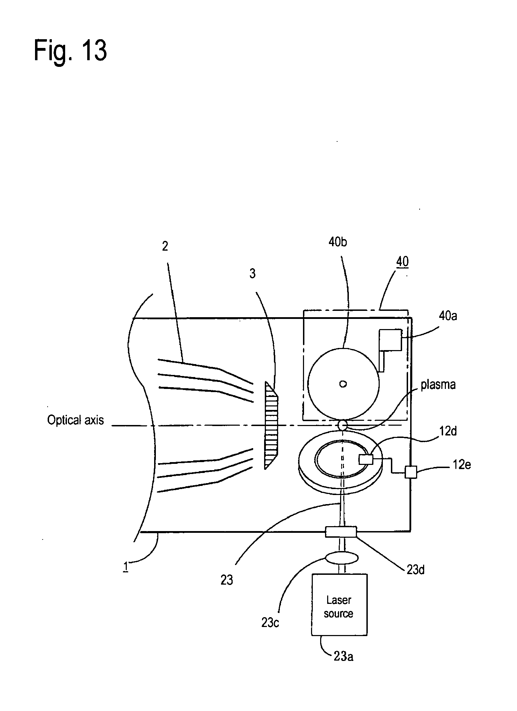

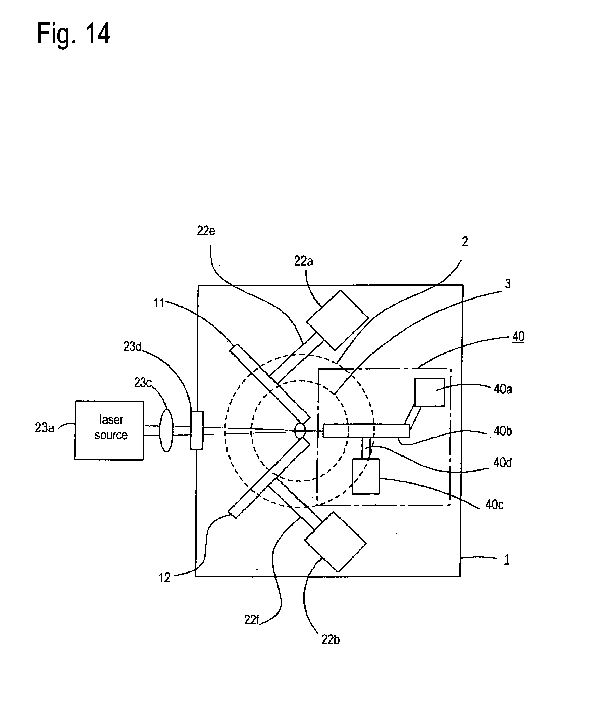

Fig. 13 is a top view of the EUV light source device according to the present invention. Fig. 14 is a side view of the EUV light source device according to the present invention. Like Fig. 12, part of the EUV light source device is omitted.

In the second alternative embodiment as shown in Figs. 12-14, liquid raw material is used as high temperature plasma raw material. Specifically, it is liquid raw material containing an extreme ultraviolet radiating species, such as Sn (tin).

The raw material supply unit 40 in the second alternative embodiment allows supplying liquid raw material to a specified space. The raw material supply unit 40 comprises a liquid raw material supply means 40a, a raw material supply disc 40b and a third motor 40c. The liquid raw material supply means 40a and a third motor drive mechanism (not shown here) are driven and controlled by a control part (not shown in Figs. 12-14).

On the lateral side of the raw material supply disc 40b is provided with a groove. First, liquid material is supplied to the groove using the liquid raw material supply means 40a. Next, the raw material supply disc 40b is rotated in one direction using the third motor 40c. The liquid raw material supplied to the groove moves as the groove is rotated.

The liquid raw material supplied to the groove is vaporized by the laser beam 23 emitted from the laser source 23a. As described above, the spreading direction of the high temperature plasma raw material depends on the position of the laser beam 23 incident on the raw material 31. The raw material supply disc 40b is arranged in such a way that the position of the laser beam 23 incident on the raw material 31 faces the discharge area.

More specifically, the raw material supply disc 40b is arranged in such a way that the lateral side on which the groove is provided faces the discharge area.

Here, the position of the raw material supply disc 40b is determined so that raw material vaporized by irradiation with the laser beam 23 can reach the discharge area.

The optical axis of the laser beam 23 emitted from the laser source 23a and the energy of the laser beam 23 are adjusted such that vaporized high temperature plasma raw material (liquid raw material) can spread in the direction of the discharge area after the liquid raw material is supplied and the laser beam 23 irradiates the groove facing the discharge area.

Here, the distance between the discharge area and the raw material supply disc 40b is set in such a way that vaporized high temperature plasma raw material spreading in the direction of the discharge area, as a result of the irradiation of the laser beam 23, can reach the discharge area while keeping a specified spatial density distribution. Since the liquid raw material supplied to the groove moves as the groove is rotated, it is possible to continuously supply the liquid raw material to the irradiating position of the laser beam 23 by continuously supplying it to the groove using the liquid raw material supply means 40a.

As shown in Figs. 12-14, in the configuration of the second alternative embodiment, the liquid raw material supplied to the groove moves in the space on the plane perpendicular to the optical axis in the vicinity of the discharge area, and the laser beam 23 irradiates the liquid raw material supplied to the groove from the direction perpendicular to the optical axis. Therefore, vaporized high temperature plasma raw material (liquid raw material) does not spread in the direction of the EUV radiation collector optics 2. Therefore, substantially no debris generated by irradiation with the laser beam 23 to high temperature plasma raw material and generated between the electrodes advances toward the EUV radiation collector optics 2.

(3) Third alternative embodiment

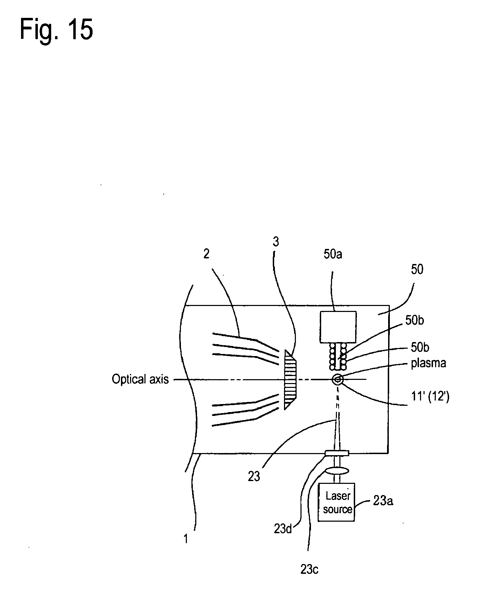

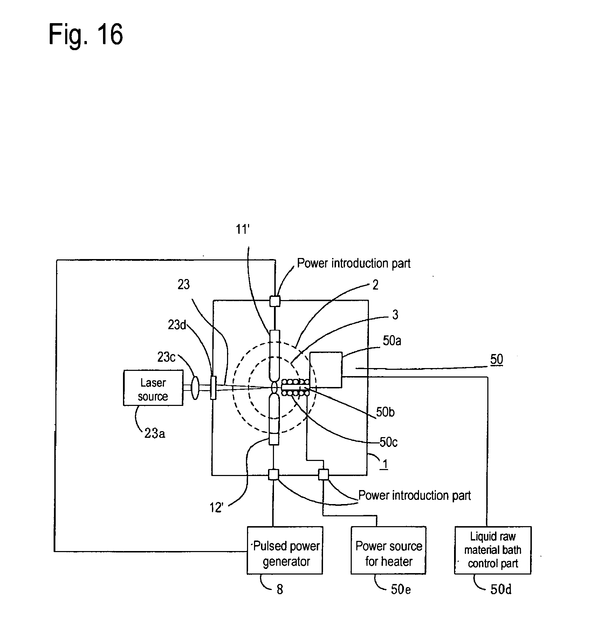

Figs. 15 & 16 are views explaining the third alternative of the present embodiment. More specifically, Fig. 15 is a top view of the EUV light source device according to the present invention. EUV radiation is extracted on the left side in the drawing. Fig. 16 is a side view of the EUV light source device according to the present invention.

In Figs. 15 & 16, the raw material supply unit 20 and electrodes of the EUV light source device in Fig. 4 are replaced. Fig 15 mainly shows the arrangement and configuration of the raw material supply unit and omits part of the EUV light source device so as to make the understanding easier. The omitted part is the same as one in Fig. 4.

In the third alternative embodiment as shown in Figs. 15 & 16, liquid raw material is used as high temperature plasma raw material. Specifically, it is liquid raw material containing an extreme ultraviolet radiating species such as Sn (tin).

The raw material supply unit 50 in the third alternative embodiment allows liquid raw material to be supplied to a specified space. The raw material supply unit 50 comprises a liquid raw material bath 50a, a capillary 50b, a heater 50c, a liquid raw material bath control part 50d and a heater power source 50e. The liquid raw material bath control part 50d and heater power source 50e are driven and controlled by a control part (not shown in Figs. 15 & 16).

The liquid raw material bath 50a is to contain liquid raw material containing an extreme ultraviolet radiating species. The liquid raw material bath 50a is provided with an extremely narrow capillary 50b. The capillary 50b is connected to the liquid raw material containing part of the liquid raw material bath 50a. In the raw material supply unit 50 according to the third alternative embodiment, liquid raw material contained in the liquid raw material bath 50a is transported inside the capillary 50b by capillary force to the tip of the capillary 50b.

The liquid raw material containing an extreme ultraviolet radiating species includes Sn (tin). The temperature of the liquid raw material bath is controlled by the liquid raw material bath control part 50d in such a way that Sn can be kept in the liquid state. The capillary 50b is heated by the heater 50c in order to prevent liquid raw material from being solidified inside of the capillary. Power is supplied to the heater 50c using the heater power source 50e.

The liquid raw material is vaporized by irradiation with the laser beam 23 emitted from a laser source 23a at a time when the liquid raw material has reached the tip of the capillary 50b. As described above, the spreading direction of high temperature plasma raw material depends on the position of the laser beam 23 incident on the raw material.

Accordingly, the tip of the capillary 50 is arranged in such a way that the position of the laser beam 23 incident on the liquid raw material, which has reached the tip of the capillary 50b, faces the discharge area. The position of the tip of the capillary 50b is determined so that raw material vaporized by irradiation with the laser beam 23 onto the liquid raw material supplied to the tip of the capillary 50b can reach the discharge area.

The optical axis of a laser beam emitted from the laser source 23a and the power of the laser beam 23 are adjusted such that vaporized high temperature plasma raw material (liquid raw material) can spread in the direction of the discharge area after the liquid raw material is supplied to the tip of the capillary 50b and the laser beam 23 irradiates the tip of the capillary.

Here, the distance between the discharge area and the tip of the capillary 50b is set in such a way that vaporized

high temperature plasma raw material spreading in the direction of the discharge area as a result of the irradiation of a laser beam can reach the discharge area while keeping a specified spatial density distribution.

Also, since the liquid raw material supplied to the tip of the capillary 50b is moved from the liquid raw material bath 50a by capillary force, it is possible to continuously supply it to a specified radiating position of the laser beam 23.

In the third alternative embodiment as shown in Figs. 15 & 16, first and second electrodes 11', 12' are columnar electrodes. The first electrode and second electrodes 11', 12' are located a specified distance from each other and are connected to the pulsed power generator 8. Needless to say, rotary electrodes may be used as these electrodes.

In the configuration of the third alternative embodiment, as shown in Figs. 15 & 16, the tip of the capillary 50b to which liquid raw material is supplied is located in the space on the plane perpendicular to the optical axis, and the laser beam 23 irradiates the liquid raw material supplied to the tip of the capillary 50b placed in the aforementioned position. Therefore, vaporized high temperature plasma raw material (liquid raw material) does not spread in the direction of the EUV radiation collector optics 2. As a result, substantially no debris generated by irradiating of high temperature plasma raw material by the laser beam 23 and generated between the electrodes advances toward the EUV radiation collector optics 2.

(4) The operation of the EUV light source device in the alternative embodiments

In the aforementioned various alternative embodiments, high temperature plasma raw material is continuously supplied to the radiation position of a laser beam. Thus, the operation of the EUV light source device according to each alternative embodiment is more or less different from the operation of the EUV light source device according to the first embodiment. A description of the operation of the EUV light source device is given below by referring to the first alternative embodiment.

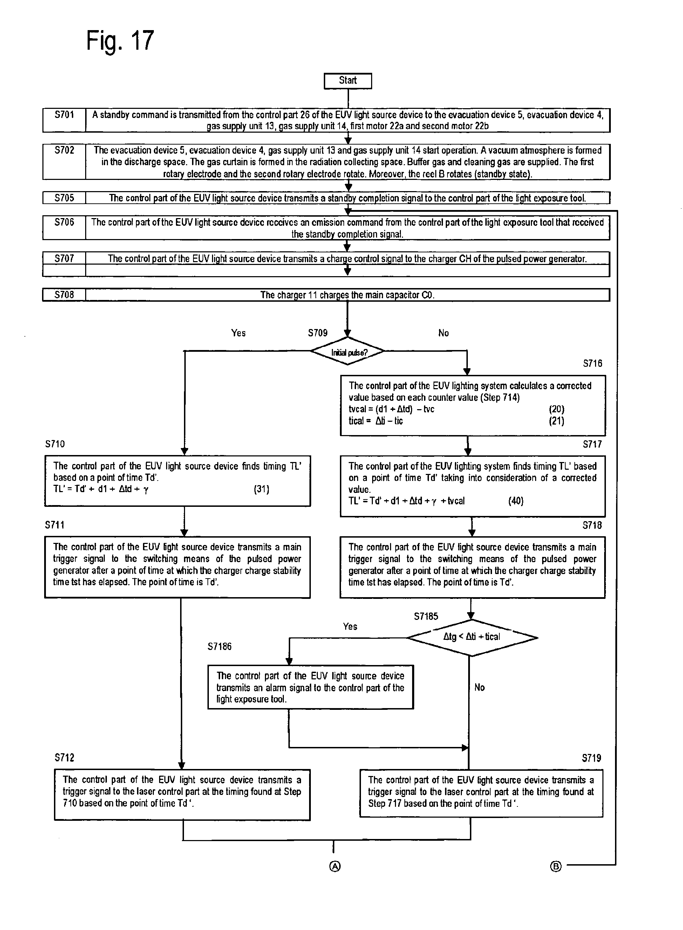

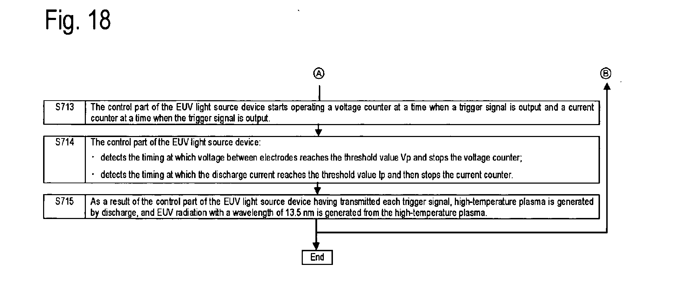

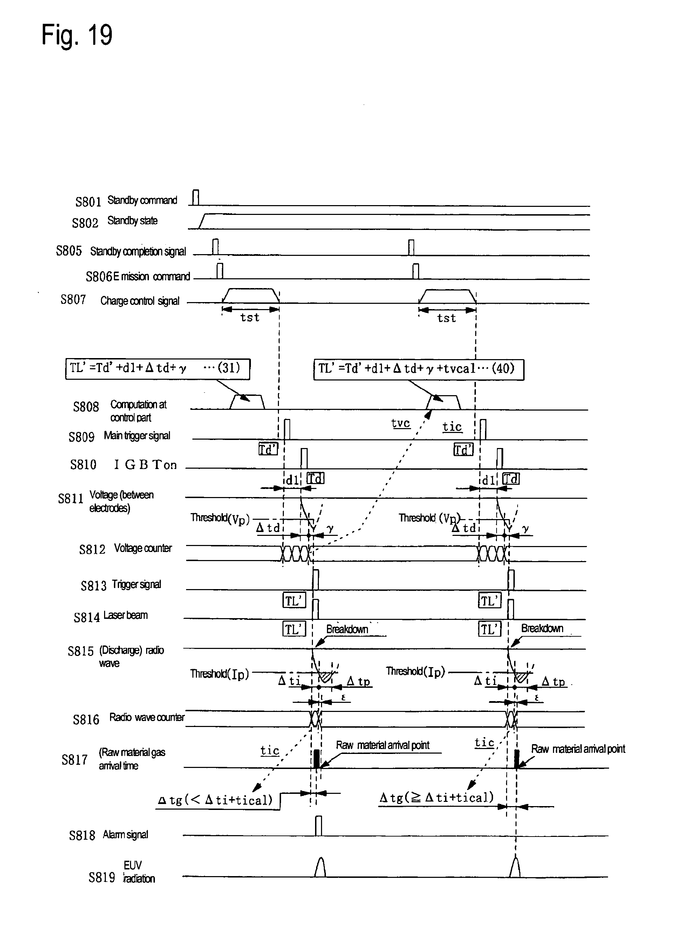

Figs. 17 & 18 are flowcharts showing the operation of the present embodiment. Fig. 19 is a time chart. A description of the operation of the present embodiment is therefore given below by referring to Figs. 17-19. Since there is no significant difference in operation between the present alternative embodiment and the first embodiment, the description is brief here for the sections that are the same as those in the aforementioned embodiment.

As described above, the control part 26 of the EUV light source device stores time data $\Delta td$, $\Delta ti$ and $\Delta tg$ as shown in Fig. 1. That is, $\Delta td$ is a period between a point of time (Td) at which a trigger signal is input to a switching means of the pulsed power generator 8 and a point of time at which the voltage between the electrodes reaches a threshold value Vp after the switching means was turned on. $\Delta ti$ is the time required for the current flowing between the electrodes to reach the threshold Ip after discharge is started. $\Delta tg$ is a period between a point of time at which a laser beam irradiates the raw material and a point of time at which at least part of the vaporized raw material reaches the discharge area.

As described above, the higher the voltage V applied to the discharge electrodes, the faster the startup of the voltage waveform between the discharge electrodes. Accordingly, the aforementioned $\Delta td$ depends on the voltage V applied to the discharge electrodes.

As described above, the control part 26 of the EUV light source device stores data on the relationship between voltage V and time $\Delta td$ found by experiments conducted in advance as a table. Moreover, the control part 26 of the EUV light source device stores correction time $\gamma$ and $\varepsilon$ and a delay time d1 between a point of time at which a main trigger signal is output to the switching means of the pulsed power generator 8 and a point of time at which the main trigger signal is input to the switching means of the pulsed power generator 8 to turn the switching means on.

First, a standby command is transmitted from the control part 26 of the EUV light source device to the evacuation devices 4, 5, gas supply units 13, 14, first motor 22a, second motor 22b and drive mechanism 30d (Step S701 in Fig. 17 and S801 in Fig. 19).

Upon receiving the standby command, as described above, the evacuation devices 4, 5, gas supply units 13, 14, first motor 22a, second motor 22b and drive mechanism 30d start operation. As a result, the discharge space 1a is placed in a vacuum atmosphere, the gas curtain is formed, and the buffer gas and cleaning gas are supplied to the EUV radiation collecting space 1b. Subsequently, the EUV radiation collecting space 1b reaches a specified pressure.

Moreover, the first motor 22a and the second motor 22b start their operation to rotate the first rotary electrode 11 and the second rotary electrode 12, respectively. The reel 30e is rotationally driven by the drive mechanism 30d. As a result, material is sent from the reel 30a and the system is put in the standby state (Step S702 in Fig. 17 and S802 in Fig. 19).

The control part 26 of the EUV light source device transmits a standby completion signal to the control part 27 of a light exposure tool (Step S705 in Fig. 17 and S805 in Fig. 19).

The control part 26 of the EUV light source device receives an emission command from the control part 27 of the light exposure tool. In the case that the light exposure tool controls the intensity of EUV radiation, the emission command includes data on the intensity of EUV radiation (Step S706 in Fig. 17 and S803 in Fig. 19).

The control part 26 of the EUV light source device transmits a charge control signal to the charger CH of the pulsed power generator 8. The charge control signal is composed of discharge start timing data, for example. As described above, if an emission command from the control part 27 of the light exposure tool contains data on the intensity of EUV radiation, the aforementioned charge control signal also includes a charging voltage data signal for the main capacitor C0.

As described above, the relationship between the intensity of EUV radiation and a charging voltage for the main capacitor C0 is found by experiments in advance to make a table for storing data on the relationship. The control part 26 of the EUV light source device stores this table and retrieves charging voltage data of the main capacitor C0 from the table based on the data on the intensity of EUV radiation contained in an emission command transmitted from the control part 27 of the light exposure tool. Based on the charging voltage data thus retrieved, the control part 26 of the EUV light source device transmits a charge control signal, which contains a charging voltage data signal to be transmitted to the main capacitor C0, to the charger CH of the power supply generator 8 (Step S707 in Fig. 17 and S807 in Fig. 19).

As described above, the charger CH charges the main capacitor C0 (Step S708 in Fig. 17). The control part 26 of the EUV light source device determines if it is the first generation of EUV radiation after operation was started (the initial pulse as used here) in Step S709 (Fig. 17). If it is the initial pulse, the procedure is moved to Step S710 from Step S709. If it is not the initial pulse, the procedure is moved to Step 716.

At Step 710, the control part 26 of the EUV light source device calculates the timing of transmitting a trigger signal to a laser control part 23b that controls the operation of the laser source 23a.

In the case of the initial pulse, the aforementioned timings are determined based on the pre-stored time data $\Delta td$, $\Delta ti$, $\Delta tg$, di and $\gamma$ because count values of voltage counter and current counter (as described below) cannot be used, and therefore, feedback correction (as described below) cannot be carried out.

As shown in Fig. 1, it is desirable to set the time TL at which the laser beam 23 is emitted based on a point of time Td at which a main trigger signal is input into the switching means of the pulsed power generator 8 to turn on the switching means.

In the present embodiment, a delay time d1 was found between a point of time Td' at which a main trigger signal was output to the switching means of the pulsed power generator 8 and a point of time Td at which the main trigger signal was input into the switching means of the pulsed power generator 8 to turn on the switching means in advance and then found the point of time Td when the switching means is turned on by correcting the point of time Td' at which a main trigger signal was output to the switching means of the pulsed power generator 8 using the aforementioned delay time d1.

Here, a delay time dL was disregarded between a point of time TL' at which a trigger signal is transmitted and a point of time at which the laser beam is irradiated because it is as small as the order of a ns.

That is, a point of time TL at which the laser beam 23 is emitted can be set based on a point of time Td at which a main trigger signal is input into the switching means of the pulsed power generator 8 by setting the timing TL' for transmitting a trigger signal to the laser control part 23b, which controls the operation of the laser source 23a, based on a point of time Td' at which the main trigger signal is output to the switching means of the pulsed power generator 8.

Based on a point of time (Td') at which a main trigger signal is transmitted, the timing TL' for transmitting a trigger signal to the laser control part 23b can be found as follows:

As described above, the timing TL at which a laser beam is irradiated is expressed by the aforementioned equation (26) based on a point of time Td at which the switching means of the pulsed power generator 8 is turned on. Accordingly, based on a point of time Td' at which a main trigger is transmitted, the timing TL' for transmitting a trigger signal to the laser control part to control the operation of the laser source 23a is expressed by the equation (28). Here, since a delay time dL is ignorably small, the timing TL' for transmitting a trigger signal is expressed as follows:

$$\text{TL}' \geq \text{Td}' + \text{d1} + \Delta td \qquad (29)$$

A point of time at which the laser beam 23 is irradiated can be delayed slightly more than $\Delta td$ in order for the laser beam 23 to be irradiated surely after a voltage between the electrodes exceeds the threshold value Vp. Given that the delay time is $\gamma$, the equation (29) can be modified to the following expression.

$$\text{TL}' \geq \text{Td}' + \text{d1} + \Delta td + \gamma \qquad (30)$$

In the present embodiment, as described above,

$$TL' = Td' + d1 + \Delta td + \gamma \qquad (31)$$

Needless to say, the setting of TL' is not limited to the equation (31). Any equation can be used as far as it satisfies the expression (30). For example, the following equation is admissible: TL' = Td' + d1 + $\Delta$td.

As described above, a period $\Delta$tg between a point of time at which the laser beam 23 irradiates the raw material 31 and a point of time at which at least part of the vaporized raw material reaches the discharge area and a point of time TL at which the laser beam irradiates the high temperature plasma raw material need to satisfy the relationship as expressed by the aforementioned equation (27).

If the equation (27) is modified to show the relationship between the timing TL' for transmitting a trigger signal to the laser control part and $\Delta$tg, the aforementioned expression (32) is obtained. As described above, the relationship between $\Delta$tg and $\Delta$ti is expressed as follows:

$$\Delta ti \leq \Delta tg \leq \Delta ti + \Delta tp \qquad (33)$$

As described above, $\Delta$tg depends on the positions of the discharge area and the raw material, the direction of irradiation of the raw material with the laser beam and the radiation energy of the laser beam. These parameters are properly set so that the expression (33) can be satisfied.

In the present embodiment, $\Delta$tg is also set in such a way that at least part of the vaporized raw material reaches the discharge area surely after discharge current exceeds the threshold value Ip. In other words, $\Delta$tg is set to be slightly longer than $\Delta$ti as described above. Given that the correction time is $\varepsilon$, the relationship between $\Delta$tg and $\Delta$ti are expressed as follows:

$$\Delta tg = \Delta ti + \varepsilon \quad (\varepsilon \leq \Delta tp) \qquad (34)$$

That is, the parameters (i.e., the positions of the discharge area and the raw material, the direction of irradiating of the raw material with the laser beam and the radiation energy of the laser beam) are properly set so that the equation (34) can be satisfied.

As described above, the timing TL' for transmitting a trigger signal based on a point of time Td' for transmitting a main trigger signal is expressed by the equation (31).

That is, in Step 710, the control part 26 of the EUV light source device finds the timing TL' for transmitting a trigger signal to the laser control part 23b based on the point of time Td' for transmitting a main trigger signal using pre-stored time data $\Delta$td, d1 and $\gamma$ and equation (31) (S808 in Fig. 19). Here, the time data $\Delta$td is retrieved from a table that stores the relationship between voltage V and time $\Delta$td.

As data on voltage V applied to the discharge electrodes 11, 12, charging voltage data of the main capacitor C0 can be used, for example, that is retrieved from a table storing data on the correlation between the intensity of EUV radiation and charging voltage to the main capacitor C0 at the time of transmitting a charge control signal to the charger CH of the pulsed power generator 8 in Step 707.

The control part 26 of the EUV light source device transmits a main trigger signal to the switching means of the pulsed power generator 8 after the charger charge stability time tst, which is a period required for the charging of the main capacitor C0 to become stable, has elapsed (Step S711 in Fig. 17 and S809 in Fig. 19).

The control part 26 of the EUV light source device transmits a trigger signal to the laser control part 23b at the timing TL' for transmitting a trigger signal to the laser control part 23b based on the point of time Td', which was found by the equation (31) based on the point of time Td' at which the main trigger signal was transmitted in Step 711, (Step S712 in Fig. 17 and S813 in Fig. 19).

The control part 26 of the EUV light source device starts operating a voltage counter at a time when a main trigger signal is output for measuring the voltage between the electrodes until it reaches the threshold Vp. It also starts operating a current counter at a time when a trigger signal is output for measuring the discharge current until it reaches the threshold value Ip (Step S713 in Fig. 18 and S812 and S816 in Fig. 19).

As described above, the voltage counter and current counter are cleared to the 0 state at a time when an emission command signal is input from the control part of the light exposure tool. As also described above, the voltage counter is used for feedback control in order to keep the time required for the voltage between the electrodes to reach the threshold value Vp constant after the output of a main trigger signal. The current counter is used for checking if the

relationship between $\Delta tg$ and $\Delta ti$ satisfies the equation (34) or not after the output of a trigger signal.

In other words, the timing TL' for transmitting a trigger signal to the laser control part 23b based on the point of time Td' at which the main trigger signal was transmitted are determined by the equation (31) at the first irradiation (i.e., the initial pulse) as described above and are determined by the values obtained by correcting the aforementioned equations (31) based on the count values of the aforementioned voltage counter and current counter at the second trial and thereafter.

The control part 26 of the EUV light source device detects the timing at which the voltage between the electrodes reaches the threshold Vp using a voltage monitor (not shown here) and then stops the voltage counter. It also detects the timing at which the discharge current reaches the threshold value Ip using a current monitor (not shown in Figs. 4 & 5) and then stops the current counter (Step S714 in Fig. 18 and S812 and S816 in Fig. 19).

In Step S711, at a time when a delay time d1 has elapsed after a main trigger signal is transmitted at the timing Td' and then the main trigger signal is input to the switching means of the pulsed power generator 8, the switching means (e.g., IGBT) is turned on (S909 and S810 in Fig. 19).

After the switching means is turned on, the voltage between the first rotary electrode 11 and the second rotary electrode 12 starts rising and, $\Delta td$ later, reaches the threshold value Vp. As described above, the threshold value Vp is a voltage value at a time when a value of the discharge current, which flows at the time of the generation of discharge, exceeds the threshold value Ip (S810 and S811 in Fig. 19).

In Step S712, as described above, a trigger signal is transmitted to the laser control part 23b at the timing TL' based on the equation (31). As a result, a laser beam irradiates the discharge area at a point of time TL which is at or after a point of time $(Td + \Delta td)$ when the voltage between the electrodes reaches the threshold value Vp (S813 and S814 in Fig. 19).

After the laser beam 23 irradiates the discharge area, discharge occurs in the discharge area. A period $\Delta ti$ after the start of the discharge, a discharge current value reaches the aforementioned threshold value Ip (S814 and S815 in Fig. 19). The threshold value Ip is the lower limit of the discharge current value required for generating EUV radiation of a specific intensity. Here, a period during which the discharge current value exceeds the threshold value Ip is $\Delta tp$.

Here, the timing at which the laser beam 23 passes through the discharge area can be considered to be substantially the same as the timing at which it irradiates the high temperature plasma raw material 31. The energy of the laser beam 23 at the position where it irradiates the high temperature plasma raw material 31, the radiating direction of the laser beam 23 and the positional relationship between the discharge area and high temperature plasma raw material 31 are properly set in such a way as to satisfy the expressions (26) and (27).

Accordingly, at least part of the vaporized raw material having a specified spatial density distribution reaches in a period during which a discharge current value exceeds the lower limit of the discharge current value required for generating EUV radiation of a specified intensity (S817 in Fig. 19).

As a result of the control part 26 of the EUV light source device having transmitted each trigger signal in Step S711 and Step 712, the discharge channel is fixed to a specified position. At a time when at least part of the vaporized raw material having a specified spatial density distribution has reached the discharge channel, the position of which has been fixed, electric discharge occurs in such a way that a discharge current value exceeds the lower limit of the discharge current value required for generating EUV radiation of a specific intensity.

The electric discharge occurs between the edges of the peripheral portions of the first rotary electrode 11 and the second rotary electrode 12 to form plasma. At a time when the plasma is heated and excited by high pulse current flowing inside the plasma, EUV radiation of 13.5 nm wavelength is generated from the high temperature plasma (Step S715 in Fig. 18).

The aforementioned specified spatial density distribution is set in such a way that EUV radiation can be generated as efficiently as possible. More specifically, the position of supplying raw material to the discharge area, the radiating direction of the laser beam to the raw material, the radiating energy of the laser beam and the like are properly set in such a way that EUV radiation can be generated as efficiently as possible.

The discharge channel is fixed to a specified position by irradiation with the laser beam 23, thereby further stabilizing the position generated by plasma.

In other words, the transmission of each trigger signal by the control part 26 of the EUV light source device allows achieving the efficient generation of EUV radiation and stabilizing the position of generating EUV radiation.

The EUV radiation emitted from the plasma passes through an opening provided in the barrier and the foil trap, is collected on the grazing incidence type EUV radiation collector optics provided in the EUV radiation collecting space and then is guided to the illumination optical system of the lithography tool (not shown here) via the EUV radiation extracting part provided in the chamber.

At the end of the initial EUV radiation, the procedure returns to Step S706 and stands by for an emission command from the light exposure tool. After receiving an emission command, the procedure moves on to Steps S707 and S708 and to Step S709. Since the next irradiation is not the initial pulse, the procedure moves from Step S709 to Step S716.

In Step 716, the control part 26 of the EUV light source device carries out the feedback calculation of the timing TL' for transmitting a trigger signal to the laser control part using the aforementioned equations (20) and (21), as shown below, based on a value in the voltage counter for a period between a point of time at which a main trigger signal is output and a point of time the voltage between the electrodes reaches the threshold value Vp and a value in the current counter for a period between a point of time at which a trigger signal is output and a point of time at which discharge current reaches the threshold value Ip, which were measured in Step S714.

$$tvcal = (d1 + \Delta td) - tvc \qquad (20)$$

$$tical = \Delta ti - tic \qquad (21)$$

Here, as described above, tvcal is a correction value of a period between a point of time at which a main trigger signal is output and a point of time the voltage between the electrodes reaches the threshold value Vp, and tvc is time measured by the voltage counter. Also, tical is a correction value of a period between a point of time at which a trigger signal is output and a point of time at which discharge current reaches the threshold value Ip, and tic is time measured by the current counter (Step S716 in Fig. 17 and S808 in Fig. 19).

As shown in the equation (20), tvcal is a correction value of the sum total of a delay time d1 between a point of time Td' at which a main trigger signal is output and a point of time at which the main trigger signal is input to the switching means of the pulsed power generator 8 to turn the switching means on and a period between a point of time at which the switching means is turned on and a point of time at which the voltage between the electrodes reaches the threshold value Vp.

As described above, a semiconductor switching element such as IGBT, which can flow high current, is frequently used as a solid switch SW, which is the switching means of the pulsed power generator 8. In the semiconductor switching element, such as IGBT, a period between a point of time at which a gate signal, which corresponds to a main trigger signal in the present embodiment, is input and a point of time at which it is turned on varies to some degree. That is, the equation (20) can correct such a variation of the switching element.

The control part 26 of the EUV light source device determines the timing TL' for transmitting a trigger signal to the laser control part based on the point of time Td' at which a main trigger signal was transmitted by the following equation taking into consideration of correction values found in Step S716 (Step S717 in Fig. 17 and S808 in Fig. 19).

$$TL' = Td' + d1 + \Delta td + \gamma + tvcal \qquad (40)$$

The control part 26 of the EUV light source device transmits a main trigger signal after the charger charge stability time tst, which is a period required for the charging of the main capacitor C0 to become stable, has elapsed (Step S718 in Fig. 17 and S809 in Fig. 19).

Next, the procedure moves on to Step S7185, where the control part 26 of the EUV light source device examines the relationship between $\Delta ti$ corrected by a correction value tical for a period between a point of time at which a trigger signal is output and a point of time at which discharge current reaches the threshold value Ip and $\Delta tg$. That is, it examines the size of $\Delta ti + tical$ and that of $\Delta tg$. If it is found as a result of the examination that $\Delta tg$ is smaller than $\Delta ti + tical$ ($\Delta tg < \Delta ti + tical$), the procedure moves on to Step S7186. On the other hand, if it is found that $\Delta tg$ is equal to or larger than $\Delta ti + tical$ ($\Delta tg \geq \Delta ti + tical$), the procedure moves on to Step 719.

In the case of $\Delta tg < \Delta ti + tical$, at least part of the vaporized raw material having a specified spatial density distribution reaches the discharge area before the discharge current reaches the threshold value Ip. For this reason, undesirable emission occurs during a period between a point of time at which at least part of the vaporized raw material having a specified spatial density distribution reaches the discharge area and a point of time at which the discharge current reaches the threshold value Ip.

As a result, radiation of wavelengths other than 13.5 nm is mixed with EUV radiation emitted from the discharge area. In other words, the spectral purity of EUV radiation emitted from the EUV light source device deteriorates. In Step S7186, the control part 26 of the EUV light source device transmits an alarm signal showing the deterioration of spectral purity to the control part 27 of the light exposure tool (S818 in Fig. 19).

If the operation of the EUV light source device should be continued even after the transmission of an alarm signal, the procedure moves on to Step S719.

If the operation of the EUV light source device should be stopped after the transmission of an alarm signal, the operation of the EUV light source device is stopped in the aforementioned Step S7186. Then, parameters such as the positions of the discharge area and the raw material, the radiating direction of the laser beam and the radiating energy of the laser beam should be reset in such a way as to satisfy the equation (34).

In the present embodiment, the operation of the EUV light source device is continued even after an alarm signal is transmitted.

In the case of $\Delta tg \geq \Delta ti + tical$ in Step S7185, at least part of he vaporized raw material reaches the discharge area after a point of time at which the discharge current reaches the threshold Ip. Accordingly, the procedure moves on to Step S719 because there is no deterioration in spectral purity.

As descried above, the purpose of the aforementioned examination in Step S7185 is to exclude the influence of a jitter of a period $\Delta ti$ between a point of time at which discharge is started and a point of time at which the current value reaches the threshold value Ip. If it is already known that a correction time $\varepsilon$ ($\varepsilon \leq \Delta tp$) in the equation (34) is fully larger than the aforementioned jitter, it is possible to omit the examination in Step S7185.

In Step 719, the control part 26 of the EUV light source device transmits the trigger signal to the laser control part at the timing TL' for transmitting a trigger signal to the laser control part based on the point of time Td', which was found by the equation (40) in Step S718 based on the point of time Td' at which the main trigger signal was transmitted to the switching means of the pulsed power generator 8 (Step S719 in Fig. 17 and S813 in Fig. 19).

Next, the procedure moves on to Step S713 in Fig. 18. The control part 26 of the EUV light source device starts operating a voltage counter at a time when a main trigger signal is output for measuring the voltage between the electrodes until it reaches the threshold Vp. It also starts operating a current counter at a time when a trigger signal is output for measuring the discharge current until it reaches the threshold Ip (S812 and S816 in Fig. 19). As described above, the voltage counter and current counter are cleared to the 0 state at a time when an emission command signal is input from the control part 27 of the light exposure tool.

As described above, the control part 26 of the EUV light source device detects the timing at which the voltage between the electrodes reaches the threshold value Vp using a voltage monitor (not shown here) and then stops the voltage counter. It also detects the timing at which the discharge current value reaches the threshold value Ip using a current monitor (not shown here) and then stops the current counter (Step S714 in Fig 18 and S812 and S816 in Fig. 19).

A main trigger signal is transmitted at the timing Td' in Step S718, and then the main trigger signal is input to the switching means of the pulsed power generator 8. Subsequently, after a delay time d1 has elapsed, the switching means is turned on (S809 and S810 in Fig. 19). Then, the voltage between first rotary electrode 11 and the second rotary electrode 12 starts rising and, a period $\Delta td$ later, reaches the threshold Vp (S810 and S811 in Fig. 19).

In Step S719, as described above, a trigger signal is transmitted to the laser control part at the timing TL' based on the equation (40). As a result, the laser beam 23 irradiates the discharge area at a point of time TL which is at or after a point of time (Td + $\Delta td$) when the voltage between the electrodes reaches the threshold value Vp (S813 and S814 in Fig. 19).

After the laser beam 23 irradiates the discharge area, discharge occurs in the discharge area. $\Delta ti$ after the start of the discharge, the discharge current value reaches the aforementioned threshold value Ip (S814 and S815 in Fig. 19). The threshold value Ip is the lower limit of the discharge current value required for generating EUV radiation of a specific intensity. Here, a period during which the discharge current value exceeds the threshold value Ip is $\Delta tp$.

Here, the timing at which the laser beam passes through the discharge area can be considered to be substantially the same as the timing at which it irradiates the high temperature plasma raw material. The energy of the laser beam at the position where it irradiates the high temperature plasma raw material, the radiating direction of the laser beam and the positional relationship between the discharge area and high temperature plasma raw material are properly set in such a way as to satisfy the expressions (26) and (27).

Accordingly, at least part of the vaporized raw material having a specified spatial density distribution reaches the discharge area in a period during which the discharge current value exceeds the lower limit of the discharge current value required for generating EUV radiation of a specified intensity (S817 in Fig. 19).

As a result of the control part 26 of the EUV light source device having transmitted each trigger signal in Step S718 and S719, the discharge channel is fixed to a specified position. At a time when at least part of the vaporized raw material having a specified spatial density distribution has reached the discharge channel, the position of which has been fixed, electric discharge occurs in such a way that the discharge current value exceeds the lower limit of the discharge current value required for generating EUV radiation of a specific intensity.

The electric discharge occurs between the edges of the peripheral portions of the first rotary electrode 11 and the second rotary electrode 12 to form plasma. At a time when the plasma is heated and excited by high pulse current flowing inside the plasma, EUV radiation with a wavelength of 13.5 nm is generated from the high temperature plasma (Step S715 in Fig. 17).

The aforementioned specified spatial density distribution is set in such a way that EUV radiation can be generated as efficiently as possible. Since the discharge channel is fixed to a specified position, the position where the plasma is generated can further be stabilized.

In other words, the transmission of each trigger signal by the control part 26 of the EUV light source device in Step S718 and Step S719 allows achieving the efficient generation of EUV radiation and stabilizing the position of generating EUV radiation.

The EUV radiation emitted from plasma passes through an opening provided in the barrier 1c and the foil trap 3, is collected on grazing incidence type EUV radiation collector optics 2 provided in the EUV radiation collecting space 1b and then is guided to the illumination optical system of a lithography tool (not shown here) via the EUV radiation extracting part 7 provided in the chamber 1.

As long as the light exposure process is continued, the steps between Step S706 and Step S715 are repeated. If the light exposure is brought to an end, the procedure also comes to an end after Step S715.

The aforementioned operation allows properly setting the timing at which a laser beam passes through a discharge area, the timing at which it irradiates the high temperature plasma raw material, the intensity of condensing the laser beam in the discharge area, the energy of the laser beam at the position where it irradiates the high temperature plasma raw material, the radiating direction of the laser beam and the positional relationship between the discharge area and the high temperature plasma raw material.

While the high temperature plasma raw material keeps a specified spatial density distribution in the discharge area after at least part of the vaporized high temperature plasma raw material 21 having a specified spatial density distribution has reached the discharge area, discharge current reaches a specified value, and then EUV radiation of a specified intensity is generated.

That is, in the present embodiment, electric discharge is initiated by irradiation with a laser beam, the position of a discharge channel is fixed in the discharge area and then discharge current reaches a specified value while the raw material maintains a specified spatial density distribution in the discharge channel, the position of which has been fixed. Accordingly, EUV radiation can be generated efficiently.

Moreover, since the discharge channel is fixed on the radiation focusing line of the laser beam, the positional stability of the starting point of EUV radiation can be enhanced.

More particularly, feedback control is carried out in the present embodiment so that a period between the beginning of an output of the main trigger signal and a point of time at which the voltage between the electrodes reaches the threshold Vp can be kept constant. Accordingly, it is possible to achieve efficient EUV radiation without fail if there occurs some variation in the operation of a semiconductor switching element such as IGBT used as a solid switch SW (i.e., a switching means of the pulsed power generator 8).

(5) Vaporized raw material emission nozzle

It is preferred that high temperature plasma raw material spreading in the direction of the discharge area after irradiation should reach the discharge area as much as possible. If a large amount of high temperature plasma raw material reaches the places other than the discharge area, the efficiency of collecting EUV radiation from the supplied high temperature plasma raw material declines, and therefore, it is not preferable. Part of high temperature plasma raw material that has reached the places other than the discharge area may come into contact with and be accumulated on the low-temperature portions of the EUV light source device as debris.

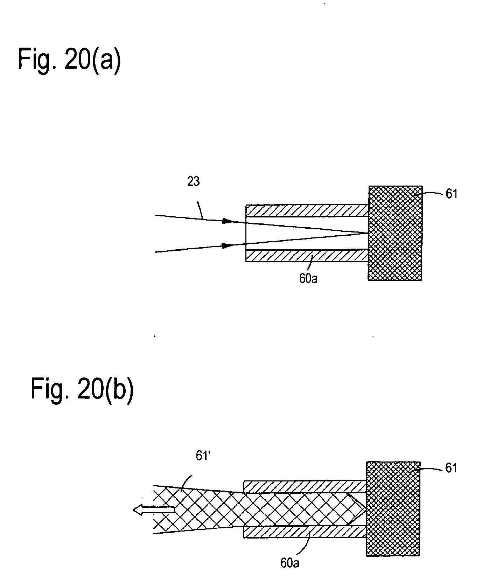

Accordingly, as shown in Fig. 20, a tubular nozzle 60a may be mounted in the position of irradiation of the high temperature plasma raw material 61 with an energy beam. Fig. 20 is a schematic view in the case of using a tubular nozzle 60a.

As shown in Fig. 20, an energy beam (i.e., the laser beam 23) passes through the through hole of the tubular nozzle 60a. At a time when the energy beam that has passed through the tubular nozzle 60a irradiates the high temperature plasma raw material 61, the raw material is vaporized. As shown in Fig. 20 (b), the vaporized raw material passes through the tubular nozzle 60a and is sprayed out of the tubular nozzle 60a.

The vaporized raw material 61' sprayed out of the tubular nozzle 9a is restricted in its spraying angle by the tubular nozzle 60a, which allows supplying vaporized raw material having a good directionality and a high density to the discharge channel.

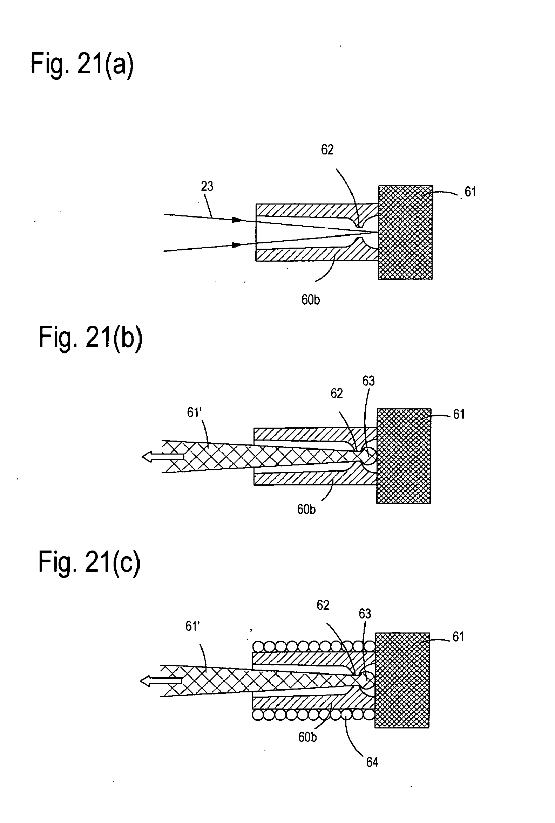

The shape of the tubular nozzle is not limited to that of a straight pipe as shown in Fig. 20. As shown in a schematic view in Fig. 21, it may be the shape of a high-speed jet nozzle 60b provided with a constricted area 62 on a section inside the nozzle.

As shown in Fig. 21(a), an energy beam passes through the through hole of the high-speed jet nozzle 60b. After the energy beam passes through the high-speed jet nozzle 60b and irradiates the high temperature plasma raw material 61, the raw material 61 is vaporized. Since the constricted area 62 is provided inside the high-speed jet nozzle 60b, pressure of the vaporized raw material abruptly increases inside the space between the constricted area 62 and the portion of the high temperature plasma raw material 61 irradiated by the energy beam (i.e., a pressure rising section 63 in Fig. 21(b)). As shown in Fig. 21(b), the vaporized raw material 61' is accelerated and sprayed out of the opening of the constricted area 62 as a high speed gas flow having a good directionality.

Here, the spraying direction of the high speed gas flow depends on the direction of the high-speed jet nozzle 60b. That is, the traveling direction of vaporized raw material does not depend on the incident direction of high temperature plasma raw material 61.

Since the opening of the constricted area 62 is small in cross section area, high temperature plasma raw material 61 may be solidified if a laser beam is not irradiated onto the high temperature plasma raw material 61 for an extended period, resulting in the obstruction of the opening. Therefore, as shown in Fig. 21(c), the high-speed jet nozzle 60b may be heated by a heater 64 or the like so as to prevent solidification of the high temperature plasma raw material inside of the high-speed jet nozzle 60b.

The tubular nozzle 60a and high-speed jet nozzle 60b as shown in Figs. 20 & 21 can be applied to the present embodiment and its alternative embodiments. The closer the tubular nozzle 60a and high-speed jet nozzle 60b are to the high temperature plasma raw material 61, the more effective.

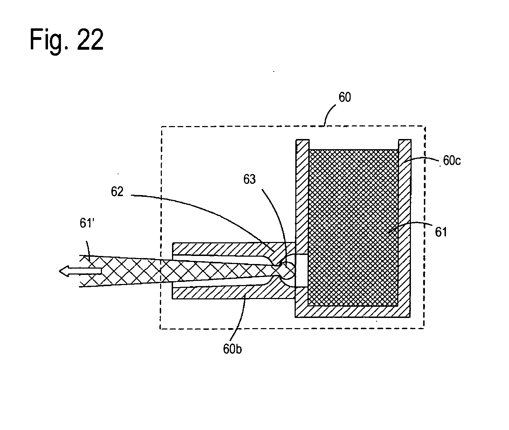

Particularly, since the high-speed jet nozzle 60b needs to be provided with a pressure rising section 63, it is desirable that the space inside the high-speed jet nozzle 60b between the constricted area 62 and the portion of high temperature plasma raw material 61 irradiated by an energy beam is as air tight as possible. For example, as shown in Fig. 22, it is desirable to use a raw material supply unit 60 in which a material containing section 60c, which contains high temperature plasma raw material 61, and a high-speed jet nozzle 60b are integrally configured.

Thus, in the EUV light source device according to the present invention, the irradiation of an energy beam allows supplying high temperature plasma raw material having a specified spatial density distribution to a discharge area, starting up electric discharge and defining a discharge channel.

In this case, it is possible to set up in such a way that a value of discharge current generated in the discharge area exceeds a specified threshold value at a time when at least part of the vaporized high temperature plasma raw material having a specified spatial density distribution reaches the discharge area by properly setting the timing at which an energy beam passes through the discharge area, the timing at which it irradiates the high temperature plasma raw material, the intensity (i.e., energy) of the energy beam in the discharge area, the energy of the energy beam at the position where it irradiates the high temperature plasma raw material, the radiating direction of the energy beam, the positional relationship between the discharge area and the high temperature plasma raw material (i.e., the position of supplying the high temperature plasma raw material relative to the discharge area) and the like. Accordingly, EUV radiation can be achieved efficiently.

(6) Adjusted irradiation

Here, the irradiation of an energy beam may be adjusted so that discharge can easily be generated between the electrodes. A description of the improved startup of discharge is given below.

As an example, a description of the steps of adjusted irradiation is given below for the EUV light source device according to the present embodiment.

In this procedure, the laser beam 23 irradiates the high temperature plasma raw material 21 one or more times while pulsed power has not been applied yet to the gap between the first discharge electrode 11 and the second discharge electrode 12 in Figs. 4 & 5. This type of the irradiation of a laser beam is referred to as adjustment irradiation as used herein.

By implementing the adjustment irradiation, vaporized high temperature plasma raw material reaches a discharge area. Part of the vaporized high temperature plasma raw material that has reached the discharge area attaches to the first discharge electrode 11 and the second discharge electrode 12.

In this state, pulsed power is applied to the gap between the first discharge electrode 11 and the second discharge electrode 12, and then an energy beam irradiates the specified position in the discharge area. As a result, part of the high temperature plasma raw material attached to the aforementioned first discharge electrode 11 and the second discharge electrode 12 is vaporized. The vaporized raw material contributes to electric discharge. Discharge therefore occurs between the electrodes with ease and certainty. Thus, the startup of electric discharge is improved.

In order for part of high temperature plasma raw material attached to discharge electrodes to be vaporized, at least part of the energy beam needs to be irradiated to the portion of the discharge electrodes where the high temperature plasma raw material is attached.

**Claims**

**1.** An extreme ultraviolet light source device, comprising:

a vessel,
a raw material supply unit for supplying liquid or solid raw material for emitting extreme ultraviolet radiation inside the vessel,
an energy beam irradiation means for irradiation of an energy beam to vaporize the raw material,
a pair of electrodes placed with a gap therebetween for generating high temperature plasma by heating and exciting the vaporized raw material using discharge in the vessel;
a pulsed power generator for supplying pulsed power to said pair of electrodes;
extreme ultraviolet radiation collector optics for collecting extreme ultraviolet radiation emitted from said high temperature plasma;
an extreme ultraviolet radiation extracting part for extracting collected extreme ultraviolet radiation in a discharge area formed by discharge in the pair of electrodes;

wherein said energy beam irradiation means emits a laser beam via the gap between the electrodes to which power is applied for irradiating the raw material supplied to a space which is outside the discharge area and which allows the vaporized raw material to reach the discharge area, and
wherein said energy beam irradiation means is adapted to start discharge inside said discharge area by said energy beam passing through the gap between the electrodes to which power is applied and defining a discharge channel at a specified position in said discharge area.

2. The extreme ultraviolet light source device according to claim 1, wherein the timing of said energy beam passing through said discharge area, the timing of said energy beam being irradiated to the high temperature plasma raw material, energy of said energy beam in said discharge area, energy of said energy beam at a position at which it irradiates the high temperature plasma raw material, the direction of said energy beam to be irradiated and the position of said high temperature plasma raw material to be supplied relative to said discharge area have been set in advance in such a way that discharge current generated in said discharge area can exceed a specified threshold value at a time at least part of said vaporized raw material, which has a specified spatial density distribution, reaches said discharge area after said energy beam was irradiated from said energy beam irradiation means.

3. The extreme ultraviolet light source device according to claim 1 or 2, wherein said raw material supply means is adapted to supply said material as droplets in the gravitational direction.

4. The extreme ultraviolet light source device according to claim 1 or 2, wherein said raw material supply means is adapted to continuously supply a linear raw material.

5. The extreme ultraviolet light source device according to claim 1 or 2, wherein said raw material supply means comprises a rotatable raw material supply disc and wherein said raw material supply means is adapted to supply said material as a liquid to a liquid raw material supply part of said raw material supply disc and wherein the liquid raw material supply part of said raw material supply disc is adapted to move the liquid material to an irradiation position of an energy beam by rotating of the raw material supply disc to which said liquid material is supplied.

6. The extreme ultraviolet light source device according to claim 1 or 2, wherein said raw material supply means comprises a capillary and is adapted to supply said material as a liquid to an irradiating position of an energy beam via said capillary.

7. The extreme ultraviolet light source device according to claim 1 or 2, wherein a tubular nozzle is provided at the position of an energy beam for irradiating said raw material and wherein said tubular nozzle is configured and arranged for spraying out at least part of the raw material vaporized by said energy beam.

8. The extreme ultraviolet light source device according to claim 7, wherein a constricted area is provided inside of said tubular nozzle.

9. The extreme ultraviolet light source device according to any one of claims 1 to 8, further comprising a magnetic field application means for applying a magnetic field to said discharge area substantially in parallel to the direction of discharge generated between said electrodes.

10. The extreme ultraviolet light source device according to any one of claims 1 to 9, said electrodes are disc-shaped and rotatable in such a way that a discharge generating position on a surface of said electrodes changes.

11. The extreme ultraviolet light source device according to claim 10, wherein edges of peripheral portions of said disc-shaped electrodes face each other with said gap therebetween.

**12.** The extreme ultraviolet light source device according to any one of claims 1 to 11,
wherein said energy beam is a laser beam.

**13.** A method of generating extreme ultraviolet radiation, comprising the steps of:

supplying a liquid or solid raw material for emitting extreme ultraviolet radiation to a space in a vessel in which a pair of electrodes to which power is applied are located,
irradiating the raw material in said space with an energy beam so as to evaporate the raw material,
delivering at least a portion of the raw material vaporized to a discharge space,
generating high temperature plasma from the raw material vaporized by heating and exciting the raw material vaporized in said discharged space using discharge from said pair of electrodes to which power is applied, and then, generating extreme ultraviolet radiation from the high temperature plasma,

wherein said energy beam, via the gap between the electrodes to which power is applied, irradiates the raw material supplied to a space which is outside of said discharge area and which allows the vaporized raw material to reach the discharge area, wherein by said laser beam passing through a gap between said electrodes to which power is applied, discharge is started in said discharge area and a discharge channel is fixed at a specified position in the discharge area.

**14.** The method of generating extreme ultraviolet radiation according to claim 13,
wherein the timing of said energy beam passing through said discharge area, the timing of said energy beam being irradiated to high temperature plasma raw material, the energy level of said energy beam in said discharge area, the energy level of said energy beam at a position at which it irradiates the high temperature plasma raw material, the direction of said energy beam and the position of said high temperature plasma raw material supplied relative to said discharge area are set in advance in such a way that discharge current generated in said discharge area will exceed a specified threshold value at a time at which at least part of said vaporized raw material, which has a specified spatial density distribution, reaches said discharge area after it is irradiated with said energy beam.

**15.** The method of generating extreme ultraviolet radiation according to claim 14,
wherein time data on discharge start timing is generated and wherein the irradiation timing of the energy beam is corrected based on said time data.

**16.** The method of generating extreme ultraviolet radiation according to claim 15,
wherein the energy beam irradiates said material at least once while discharge by the pair of electrodes is stopped in advance of irradiation by the energy beam for which the irradiation timing has been corrected.

Fig. 1(a)    Power trigger
             (IGBT on)                    ⊓
                                          Td

Fig. 1(b)    Voltage (between       Δtd
             electrodes)

                                          Threshold value
                                          (Vp)

Fig. 1(c)    Laser beam (for
             initiation and raw           ⊓
             material)                    TL
                                                              Breakdown point

Fig. 1(d)    (Discharge) current

             Threshold value
             (Ip)
                              Δti        Δtp

Fig. 1(e)    Raw material
             arrival timing              ▮
                                                Raw material gas
                              Δtg                arrival point

Fig. 1(f)    EUV radiation               ∧

# Fig. 2

21 (droplets)

Discharge channel

Focus point

Rayleigh range

12

23c

23a

Laser source

23

11

Fig. 3

12

Discharge channel

23c

21 (droplets)

232

Linear radiation
condensation

Laser source    23a

23

231

11

# Fig. 4

## Fig. 5

# Fig. 6

# Fig. 7

Start

| | |
|---|---|
| S501 | A standby command is transmitted from the control part 26 of the EUV light source device to the evacuation device 5, evacuation device 4, gas supply unit 13, gas supply unit 14, first motor 22a and second motor 22b |
| S502 | The evacuation device 5, evacuation device 4, gas supply unit 13 and gas supply unit 14 start operation. A vacuum atmosphere is formed in the discharge space. The gas curtain is formed in the radiation collecting space. Buffer gas and cleaning gas are supplied. The first rotary electrode and the second rotary electrode rotate (standby state). |
| S503 | The control part of the EUV light source device transmits an operation start command signal to the raw material supply unit and the raw material monitor. |
| S504 | The raw material supply unit makes high-temperature plasma raw material droplets and starts supplying them dropwise. The raw material monitor transmits a raw material detection signal to the control part of the EUV light source device at a time when raw material reaches the position P1. |
| S505 | The control part of the EUV light source device transmits a standby completion signal to the control part of a light exposure unit |
| S506 | The control part of the EUV light source device receives an emission command from the control part of the light exposure tool that received the standby completion signal. |
| S507 | The control part of the EUV light source device transmits a charge control signal to the charger CH of the pulsed power generator. |
| S508 | The charger 11 charges the main condenser C0. |

S509 Initial pulse?

Yes — S510

No — S516

S510
The control part of the EUV light source device finds timings Td', T1' and TL' based on a point of time Tm.

$$Td' = Tm + (\Delta tm - \Delta td) - dl - \gamma \quad (38)$$
$$T1' = Tm + \Delta tm \quad (37)$$

S511
The control part of the EUV light source device makes a reference point of time Tm at a time when it detects a raw material detection signal from the raw material monitor for the first time after the charger charge stability time tst has elapsed.

S516
The control part of the EUV light source device calculates a corrected value based on each counter value (Step 514)

$$tvcal = (d1 + \Delta td) - tvc \quad (20)$$
$$tical = \Delta ti - tic \quad (21)$$

S517
The control part of the EUV light source device finds timings Td', and TL' based on a point of time Tm taking into consideration of corrected values.

$$Td' = Tm + (\Delta tm - \Delta td) - dl - \gamma - tvcal \quad (39)$$
$$T1' = Tm + \Delta tm \quad (37)$$

S518
The control part of the EUV light source device makes a reference point of time Tm at a time when it detects a raw material detection signal from the raw material monitor for the first time after the charger charge stability time tst has elapsed.

S5185 $\Delta tq < \Delta ti + tical$

Yes — S5186

No

S5186
The control part of the EUV light source device transmits an alarm signal to the control part of the light exposure tool.

S512
The control part of the EUV light source device transmits a main trigger signal and a trigger signal to the switching means of the pulsed power generator and the laser control part, respectively, at the timing found at Step 510 based on the point of time Tm.

S519
The control part of the EUV light source device transmits a main trigger signal and a trigger signal to the switching means of the pulsed power generator and the laser control part, respectively, at the timing found at Step 517 based on the point of time Tm.

Ⓐ

Ⓑ

## Fig. 8

Ⓐ                                                                          Ⓑ

| S513 | The control part of the EUV light source device starts operating a voltage counter at a time when a trigger signal is output and a current counter at a time when the trigger signal is output. |
|------|---|
| S514 | The control part of the EUV light source device: <br> • detects the timing at which voltage between electrodes reaches the threshold value Vp and stops the voltage counter; <br> • detects the timing at which the discharge current reaches the threshold value Ip and then stops the current counter. |
| S515 | As a result of the control part of the EUV light source device having transmitted each trigger signal, high-temperature plasma is generated by discharge, and EUV radiation with a wavelength of 13.5 nm is generated from the high-temperature plasma. |

End

# Fig. 9

$$Td' = Tm + (\Delta tm - \Delta td) - dl - \gamma \quad \cdots (38)$$
$$TL' = Tm + \Delta tm \quad \cdots (37)$$

$$Td' = Tm + (\Delta tm - \Delta td) - dl - \gamma - tvcal \quad \cdots (39)$$
$$TL' = Tm + \Delta tm \quad \cdots (37)$$

# Fig. 10

# Fig. 11

# Fig. 12

Optical axis

2
3
22a
22e
11
plasma
40b
12
22f
22b
1
23

# Fig. 13

## Fig. 14

# Fig. 15

Optical axis

2  3  50a  50  50b  50b  plasma  11' (12')

23  23a  Laser source  23d  23c  1

# Fig. 16

# Fig. 17

```
Start
```

| S701 | A standby command is transmitted from the control part 26 of the EUV light source device to the evacuation device 5, evacuation device 4, gas supply unit 13, gas supply unit 14, first motor 22a and second motor 22b |

| S702 | The evacuation device 5, evacuation device 4, gas supply unit 13 and gas supply unit 14 start operation. A vacuum atmosphere is formed in the discharge space. The gas curtain is formed in the radiation collecting space. Buffer gas and cleaning gas are supplied. The first rotary electrode and the second rotary electrode rotate. Moreover, the reel B rotates (standby state). |

| S705 | The control part of the EUV light source device transmits a standby completion signal to the control part of the light exposure tool. |

| S706 | The control part of the EUV light source device receives an emission command from the control part of the light exposure tool that received the standby completion signal. |

| S707 | The control part of the EUV light source device transmits a charge control signal to the charger CH of the pulsed power generator. |

| S708 | The charger 11 charges the main capacitor C0. |

Yes     S709     No

Initial pulse?

**S716**

The control part of the EUV lighting system calculates a corrected value based on each counter value (Step 714)
$$tvcal = (d1 + \Delta td) - tvc \qquad (20)$$
$$tical = \Delta ti - tic \qquad (21)$$

**S710**

The control part of the EUV light source device finds timing TL' based on a point of time Td'.
$$TL' = Td' + d1 + \Delta td + \gamma \qquad (31)$$

**S717**

The control part of the EUV lighting system finds timing TL' based on a point of time Td' taking into consideration of a corrected value.
$$TL' = Td' + d1 + \Delta td + \gamma + tvcal \qquad (40)$$

**S711**

The control part of the EUV light source device transmits a main trigger signal to the switching means of the pulsed power generator after a point of time at which the charger charge stability time tst has elapsed. The point of time is Td'.

**S718**

The control part of the EUV light source device transmits a main trigger signal to the switching means of the pulsed power generator after a point of time at which the charger charge stability time tst has elapsed. The point of time is Td'.

**S7185**

Yes

$\Delta tg < \Delta ti + tical$

**S7186**

The control part of the EUV light source device transmits an alarm signal to the control part of the light exposure tool.

No

**S712**

The control part of the EUV light source device transmits a trigger signal to the laser control part at the timing found at Step 710 based on the point of time Td '.

**S719**

The control part of the EUV light source device transmits a trigger signal to the laser control part at the timing found at Step 717 based on the point of time Td '.

Ⓐ      Ⓑ

# Fig. 18

Ⓐ                                                                                                    Ⓑ

| S713 | The control part of the EUV light source device starts operating a voltage counter at a time when a trigger signal is output and a current counter at a time when the trigger signal is output. |
|------|-----------------------------------------------------------------------------------------------------------------------------------------------------------------------------------------------------|
| S714 | The control part of the EUV light source device:<br><br>· detects the timing at which voltage between electrodes reaches the threshold value Vp and stops the voltage counter;<br><br>· detects the timing at which the discharge current reaches the threshold value Ip and then stops the current counter. |
| S715 | As a result of the control part of the EUV light source device having transmitted each trigger signal, high-temperature plasma is generated by discharge, and EUV radiation with a wavelength of 13.5 nm is generated from the high-temperature plasma. |

End

# Fig. 19

S801 Standby command

S802 Standby state

S805 Standby completion signal

S806 Emission command

S807 Charge control signal

$$TL' = Td' + d1 + \Delta td + \gamma \quad \cdots (31)$$

$$TL' = Td' + d1 + \Delta td + \gamma + tvcal \cdots (40)$$

S808 Computation at control part

S809 Main trigger signal

S810 IGBT on

S811 Voltage (between electrodes)

Threshold (Vp)

S812 Voltage counter

S813 Trigger signal

S814 Laser beam

S815 (Discharge) radio wave

Threshold (Ip)

S816 Radio wave counter

S817 (Raw material gas arrival time)

Raw material arrival point

$\Delta tg (< \Delta ti + tical)$

$\Delta tg (\geqq \Delta ti + tical)$

S818 Alarm signal

S819 EUV radiation

Fig. 20(a)

Fig. 20(b)

## Fig. 21(a)

## Fig. 21(b)

## Fig. 21(c)

Fig. 22

Europäisches
Patentamt

European
Patent Office

Office européen
des brevets

**EUROPEAN SEARCH REPORT**

Application Number

EP 08 01 8235

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2005/004555 A (COMMISSARIAT ENERGIE ATOMIQUE [FR]; SCHMIDT MARTIN [FR]; LEBERT RAINER) 13 January 2005 (2005-01-13) <br> * abstract; figures 1-3 * <br> * page 3, line 8 - page 12, line 17 * <br> ----- | 1-4,9-14 | INV. <br> G03F7/20 <br> H05G2/00 <br><br> ADD. <br> G21K1/00 |
| D,A | US 6 972 421 B2 (MELNYCHUK STEPHAN T [US] ET AL) 6 December 2005 (2005-12-06) <br> * abstract; figures 4B,4C,17,18D * <br> * column 17, line 60 - column 19, line 21 * <br> * column 23, lines 29-37 * <br> * column 24, line 30 - column 25, line 6 * <br> * column 28, line 30 - column 29, line 20 * <br> ----- | 1,3,4,9, 12,13 | |
| A | US 4 504 964 A (CARTZ LOUIS [US] ET AL) 12 March 1985 (1985-03-12) <br> * abstract; figures 1,2; examples 5,15 * <br> * column 2, line 32 - column 3, line 6 * <br> ----- | 1,12,13 | |
| P,X | EP 1 883 280 A (USHIO ELECTRIC INC [JP]) 30 January 2008 (2008-01-30) <br> * abstract; claim 1; figures 1,4,5,8 * <br> * paragraphs [0032] - [0118] * | 1-3,9-12 | TECHNICAL FIELDS SEARCHED (IPC) <br><br> G03F <br> H05G <br> G21K |
| P,A | | 13-15 | |
| P,X | EP 1 976 344 A (TOKYO INST TECH [JP]; USHIO ELECTRIC INC [JP]) 1 October 2008 (2008-10-01) <br> * abstract; claim 1; figures 1-3,9,10,12,16,18-25 * <br> * paragraphs [0113] - [0464] * | 1-12 | |
| P,A | ----- | 13-15 | |

The present search report has been drawn up for all claims

| Place of search | Date of completion of the search | Examiner |
|---|---|---|
| The Hague | 12 December 2008 | Remy, Jérôme |

EPO FORM 1503 03.82 (P04C01)

## ANNEX TO THE EUROPEAN SEARCH REPORT
## ON EUROPEAN PATENT APPLICATION NO.

EP 08 01 8235

This annex lists the patent family members relating to the patent documents cited in  the above-mentioned European search report.
The members are as contained in the European Patent Office EDP file on
The European Patent Office is in no way liable for these particulars which are merely given for the purpose of information.

12-12-2008

| Patent document cited in search report | | Publication date | Patent family member(s) | | Publication date |
|---|---|---|---|---|---|
| WO 2005004555 | A | 13-01-2005 | AU 2003264266 A1 | | 21-01-2005 |
| | | | CN 1820556 A | | 16-08-2006 |
| | | | JP 2007515741 T | | 14-06-2007 |
| | | | US 2008116400 A1 | | 22-05-2008 |
| US 6972421 | B2 | 06-12-2005 | US 2004108473 A1 | | 10-06-2004 |
| US 4504964 | A | 12-03-1985 | NONE | | |
| EP 1883280 | A | 30-01-2008 | KR 20080011048 A | | 31-01-2008 |
| | | | US 2008048134 A1 | | 28-02-2008 |
| EP 1976344 | A | 01-10-2008 | US 2008237501 A1 | | 02-10-2008 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005522839 A
- US 6972421 B2
- JP 2004214656 A
- US 7247866 B

**Non-patent literature cited in the description**

- Status and Prospects of Research on EUV (Extreme Ultraviolet) Light Sources for Lithography. *J. Plasma Fusion Res.,* March 2003, vol. 79 (3), 219-260